# EUROPEAN PATENT APPLICATION

(11) **EP 4 506 702 A1**
(43) Date of publication of application: **12.02.2025**
(21) Application number: 24184351.5
(22) Date of filing: 25.06.2024
(51) Int. Cl.: G01R 31/317, G01R 31/3185, G01R 31/28, H01L 25/065

(54) **DEVICE, METHOD AND SYSTEM FOR IN-FIELD LANE TESTING AND REPAIR WITH A THREE-DIMENSIONAL INTEGRATED CIRCUIT**

(30) Priority: 11.08.2023 US 202318233199
(71) Applicant: INTEL Corporation, Santa Clara, CA 95054 (US)
(72) Inventor: Su, Fei, Ann Arbor, MI 48105 (US); Kandula, Rakesh, 560035 Bangalore Karnataka (IN)
(74) Representative: Samson & Partner Patentanwälte mbB

(57) **Abstract**

Techniques and mechanisms for an integrated circuit (IC) die to support in-field testing and/or repair of a lane in a three-dimensional (3D) IC which is formed with multiple IC dies (110, 150). In an embodiment, the 3D IC comprises test units which each correspond to a different partition comprising respective circuit resources. During in-field operation of the 3D IC, a given test unit is operable to detect both a first condition wherein two partitions are each in an idle state, and a second condition wherein a first link between the two partitions fails to satisfy a performance criteria. The idle states are indicated by a power management controller (PMC) agent (120) during runtime operation of the 3D IC. In another embodiment, one or more test units configure an operational mode, based on the detected conditions, to substitute communication via the first lane with communication via a repair lane.

## Description

### BACKGROUND

### 1. Technical Field

This disclosure generally relates to performance testing for inter-die communications, and more particularly, but not exclusively, to in-field testing and repair of a lane three-dimensional (3D) integrated circuit (IC).

### 2. Background Art

Over time, the design of integrated circuits (ICs) has grown increasingly complex in the pursuit of greater computational throughput, efficiency and reduced power consumption. Interconnect scaling is a major barrier to improvements in IC performance. Interconnect scaling is a dominant contributor to circuit latency and power consumption. Three-dimensional (3-D) integration, particularly stacked 3D ICs, is one technology to help overcome this barrier. Compared to traditional two-dimensional (2D) ICs, 3D stacked ICs have significantly smaller average interconnect length, i.e., the distance between discrete ICs that are communicatively connected through an interconnect, which is a communication medium. The use of 3D stacked ICs provides shorter interconnect lengths. As a result of the shorter interconnect lengths, 3D stacked ICs have lower power consumption and smaller form factors, in comparison to a 2D IC with similar computational capabilities.

ICs are often formed on a die (plural dice), which comprises a block of semiconducting material on which a given IC is fabricated. Dice can be designed using different technologies. These die fabrication technologies can be integrated using 3D stacking of ICs thereby improving system integration efficiency. Such stacking is usually applied with any of various computing architectures including system on a chip (SOC) architectures.

Two common approaches to stacking dies in 3D space are "face-to-face" (F2F) bonding and "face-to-back" (F2B) bonding. In F2B bonding, the outermost metal layer of one die (the face) is connected to the TSV (through-silicon via) on the substrate layer of the other die (the back). By contrast, F2F bonding connects the two dice's metal layer through micro-bump, and TSV is dedicated to connect any primary input/output (IO) to package bump. A 'bump' in this context refers to an interface often in a connection package for interfacing a die with a package or housing for an IC or between a packaged IC and a circuit board or another packaged IC.

However, the use of these 3D stacked ICs presents problems with respect to testing the operation of each of the stacked ICs and the interconnects between them. As the number and variety of 3D IC technologies continue to grow, there is expected to be an increased premium placed on solutions which improve how 3D IC performance problems are detected and addressed.

### BRIEF DESCRIPTION OF THE DRAWINGS

The various embodiments of the present invention are illustrated by way of example, and not by way of limitation, in the figures of the accompanying drawings and in which:
FIG. 1 shows a functional block diagram illustrating features of a system to determine whether in-field lane repair is to be performed according to an embodiment.
FIG. 2 shows a flow diagram illustrating features of a method to perform in-field operations with a 3D IC according to an embodiment.
FIG. 3 shows a functional block diagram illustrating features of a die to selectively substitute a 3D IC lane with a replacement 3D IC lane according to an embodiment.
FIG. 4 shows a functional block diagram illustrating features of a system to perform in-field lane repair in a multi-partition clock domain according to an embodiment.
FIG. 5 shows a functional block diagram illustrating features of a die to configure in-field lane repair functionality of a built-in self-test unit according to an embodiment.
FIGs. 6A, 6B show functional block diagrams each illustrating respective features of a system provide various modes of operation which facilitate in-field lane repair according to an embodiment.
FIG. 7 shows a functional block diagram illustrating features of a system to facilitate predictive in-field lane repair functionality according to an embodiment.
FIG. 8 shows a functional block diagram illustrating features of a device to provide in-field lane testing and repair functionality according to an embodiment.
FIG. 9 illustrates an exemplary system.
FIG. 10 illustrates a block diagram of an example processor that may have more than one core and an integrated memory controller.
FIG. 11A is a block diagram illustrating both an exemplary in-order pipeline and an exemplary register renaming, out-of-order issue/execution pipeline according to examples.
FIG. 11B is a block diagram illustrating both an exemplary example of an in-order architecture core and an exemplary register renaming, out-of-order issue/execution architecture core to be included in a processor according to examples.
FIG. 12 illustrates examples of execution unit(s) circuitry.
FIG. 13 is a block diagram of a register architecture according to some examples.

### DETAILED DESCRIPTION

Embodiments discussed herein variously provide techniques and mechanisms for a given lane, which facilitates inter-die communication, to be tested in-field, and optionally substituted with another line for such inter-die communication. The terms "repair lane" and "substitute lane" are variously used herein to refer to a lane which is available to be used as an alternative to some other lane for inter-die communications. Unless otherwise indicated, a repair lane is one which is not yet allocated for use in inter-die communication. A lane which has been used (and, for example, is being used) for inter-die communications, and which is a candidate to be replaced by a repair lane, is referred to herein as a "functional lane."

However, in some embodiments, a given lane is both a functional lane and a candidate to be used as a substitute for another functional lane - e.g., wherein a repair lane (not-yet-allocated for use) is similarly a candidate to be used as a substitute for the given functional lane. By way of illustration and not limitation, in some embodiments, repairing a functional lane comprises decoupling that functional lane from both first transmitter (Tx) circuitry of a first die, and first receiver (Rx) circuitry of a second die, wherein the repairing further comprises coupling a repair lane to the first Tx circuitry and to the first Rx circuitry.

However, in other embodiments, lane repair operations comprise decoupling a first functional lane from both first Tx circuitry of a first die and first Rx circuitry of a second die, wherein the operations further comprise decoupling a second functional lane from second Tx circuitry of the first die and from second Rx circuitry of the second die. Furthermore, such repair operations comprise coupling the second functional lane to the first Tx circuitry and to the first Rx circuitry, and coupling a repair lane to the second Tx circuitry and to the second Rx circuitry. It is to be understood that "a lane" or "the lane" (i.e., without the adjective "repair" or "substitute") refers herein to a functional lane, unless otherwise indicated. Some embodiments extend this type of lane repair - e.g., wherein switch circuitry is operated to variously shift the respective correspondences of two or more functional lanes each to a respective Tx circuit in a sequence of Tx circuits, and each to a respective Rx circuit in a sequence of Rx circuits. After such operation, one functional lane is disabled from participating in communications between any of the Tx circuits and Rx circuits - e.g., wherein a repair lane is coupled to be a substitute for that one functional lane.

Three-dimensional (3D) integrated circuit, or "3D IC", technology been used extensively in various packaged system architectures. These 3D IC technologies variously provide a three-dimensional integrated circuit (IC) wherein multiple integrated circuit (IC) dies or wafers are vertically stacked together - e.g., into a single package. Within such a package, dies are variously interconnected using through-silicon vias (TSVs), hybrid bonding, or the like.

In a typical example of a 3D IC system, multiple dies are variously coupled with one another to form one or more stacked arrangements. By way of illustration and not limitation, one or more dies - e.g., including some or all of a compute die, an input/output (IO) expansion die, a system-on-chip (SOC) die, a graphics processor (GFX) die, or the like - are variously coupled on an underlying die which, for example, comprises a cache memory and/or any of various other memory resources. For a given communication in such a 3D IC system, one die is to operate as a transmitter (Tx) die, and another die is to operate as a receiver (Rx) die. For example, an SoC die acts as transmit die with respect to a communication via a first path (or "lane" herein), wherein a compute die acts as receive die for said communication.

Some embodiments variously include or otherwise facilitate the substitution of one signal communication path (lane) with an alternative signal communication path - e.g., based on a determination that the one signal communication path is defective or, according to some predetermined criteria, is expected to become defective. In various embodiments, a 3D IC system comprises at least one lane - referred to herein as a "repair lane" or a "redundant lane" - which is available to be switchedly coupled to a respective transmit die (and/or to a respective receiver die). For example, such a repair lane is available to substitute for a defective lane - e.g., wherein, after such substitution, the repair lane is used in place of the defective lane for runtime signal communications and/or other suitable functional operations.

Previous technologies substitute a defective lane with a repair lane during a manufacturing stage or a packaging stage - e.g., before the die in question (or a package including said die) is sent to an original equipment manufacturer, an end user, or other such customer. For example, the die in question (or a 3D IC formed with said die) includes or is otherwise coupled to a test access point (TAP) by which the die or 3D IC is subjected to lane testing by an external test unit. However, existing methods of testing and repairing lanes cannot be implemented directly in-field, at least not without significantly impacting performance of an in-field system. For example, one main reason is that lane testing is performed for transmitter and receiver dies which are in a single synchronous clock domain. In many use cases, such a synchronous clock domain covers distinct transmitter resources and receiver resources, which - according to existing techniques - each need to be in a respective IDLE state during lane testing. However, for various data centers and server SOCs (for example), it is unlikely that such multiple resources would each be in a respective IDLE state at the same time.

Existing lane testing mechanisms - which, for example, are used off-line in a lab setting and/or during any of various manufacturing stages - have not needed to take into account whether, at a resource-specific level of granularity, a particular one resource in a set of transmitter resources and receiver resources is currently in an IDLE state which takes place during in-field operation. In an example embodiment, one such resource is transmitter circuitry or receiver circuitry of one die, wherein said resource is configured for communication with another such resource, which is receiver circuitry or transmitter circuitry of another die (and which is to operate in the same common clock domain). In a typical 3D IC system, only a microcontroller, such as a power management controller (PMC), has relatively granular knowledge of which specific transmitter resource(s) or receiver transmitter resource(s), if any, are currently in an IDLE state.

For at least these reasons, existing techniques are unable to efficiently screen and repair 3D IC lane defects which occur in-field. Some of these existing techniques would require, at least, that multiple dies of a 3D IC system be brought offline to enable lane testing and repair. However, many end users (datacenters, for example) are highly sensitive to such constraints.

The technologies described herein may be implemented in one or more electronic devices. Non-limiting examples of electronic devices that may utilize the technologies described herein include any kind of mobile device and/or stationary device, such as cameras, cell phones, computer terminals, desktop computers, electronic readers, facsimile machines, kiosks, laptop computers, netbook computers, notebook computers, internet devices, payment terminals, personal digital assistants, media players and/or recorders, servers (e.g., blade server, rack mount server, combinations thereof, etc.), set-top boxes, smart phones, tablet personal computers, ultra-mobile personal computers, wired telephones, combinations thereof, and the like. More generally, the technologies described herein may be employed in any of a variety of electronic devices including one or more IC dies which each include a respective built-in self-test (BIST) unit to facilitate in-field lane test and repair functionality.

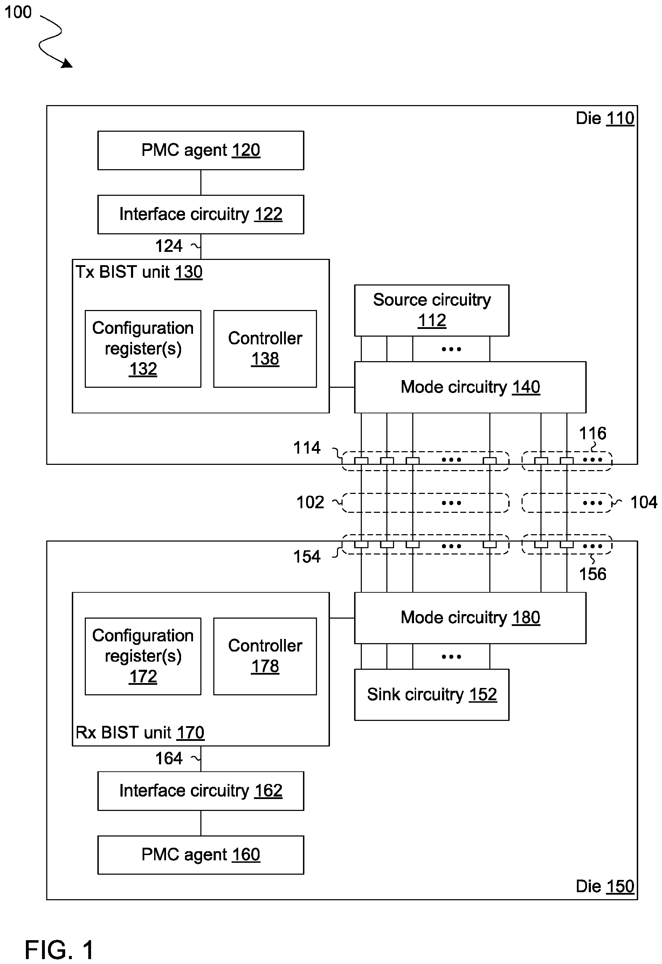

FIG. 1 shows features of a system 100 to determine whether in-field lane repair is to be performed according to an embodiment. The system 100 illustrates one example of an embodiment which supports an evaluation of one or more in-field performance characteristics of a given functional lane. In an embodiment, system 100 adapts or otherwise improves on existing techniques by facilitating in-field lane testing and repair. For example, system 100 improves upon various existing techniques at least insofar as it enables in-field detection of a defective lane, without requiring that a cluster of resources (in a SoC, server, client platform or other such system) be brought entirely offline. In one such embodiment, system 100 is operable to perform a lane repair while first resources in a clock domain are each in a respective idle state, and while other resources in the same clock domain - e.g., including other signal source circuits and/or other signal sink circuits - are each in a respective active (that is, non-idle) state.

As shown in FIG. 1, system 100 comprises integrated circuit (IC) dice 110, 150 which are coupled to each other in a 3D IC arrangement which comprises one or more functional lanes (such as the illustrative lanes 102 shown) and one or more repair lanes (such as the illustrative repair lanes 104 shown). A first hardware interface of die 110 comprises conductive contacts 114 (e.g., comprising metal pads, balls, bumps, or the like) and conductive contacts 116, wherein a second hardware interface of die 150 similarly comprises conductive contacts 154 and conductive contacts 156. In the example embodiment shown, conductive contacts 114 are variously coupled, via lanes 102, each to a different respective one of conductive contacts 154 of die 150 - e.g., wherein conductive contacts 116 are variously coupled, via repair lanes 104, each to a respective one of conductive contacts 156.

In an embodiment, die 110 comprises source circuitry 112, mode circuitry 140, a transmit (Tx) built-in self test (BIST) unit 130, a power management control (PMC) agent 120, and interface circuitry 122. Similarly, die 150 comprises sink circuitry 152, mode circuitry 180, a receive (Rx) BIST unit 170, a PMC agent 160, and interface circuitry 162. In some alternative embodiments, functionality of PMC agents 120, 160 are combined in a single PMC agent. Additionally or alternatively, PMC agent 120 is external to die 110 and/or PMC agent 160 is external to die 150, in some other embodiments.

In various embodiments, Tx BIST unit 130 and Rx BIST unit 170 - e.g., each comprising any of various suitable types of hardware, firmware, and/or executing software - provide functionality to perform in-field lane testing based on one or more idleness states each for a different respective partition of a clock domain. In this particular context, "partition" refers herein to a set of circuit resources for which lane test and repair functionality is supported by a corresponding test unit (such as a BIST unit). In some embodiments, a 3D IC comprises multiple set of circuit resources which are partitioned at least insofar as each of the sets corresponds to, and is supported by, a different respective test unit. In one such embodiment, sets of resources are partitioned from each other in one or more additional or alternative respects. By way of illustration and not limitation, a set of circuit resources of one die is partitioned from another set of circuit resources of a different die, in an embodiment. Alternatively or in addition, different sets of circuit resources of the same die are partitioned from one another according to their respective functions - e.g., wherein some or all signal source resources of a given die are partitioned from some or all signal sink resources of that same given die. In some embodiments, multiple partitions of a 3D IC are each to operate in the same clock domain.

In the example embodiment shown, a first partition of the 3D IC comprises source circuitry 112 of die 110, which includes any of various suitable circuits to generate, forward or otherwise provide one or more signals to be communicated from die 110 via the first hardware interface. Furthermore, a second partition of the 3D IC comprises sink circuitry 152 of die 150, which includes any of various suitable circuits to receive (and, for example, to parse, decode, forward and/or otherwise process) one or more signals which are communicated to die 150 via the second hardware interface.

Some embodiments variously perform in-field lane repair based on lane testing such as that which is supported with Tx BIST unit 130 and Rx BIST unit 170. In one such embodiment, in-field lane repair is performed on a predictive basis - e.g., wherein a functional lane is substituted with a repair lane prior to the manifestation of an expected future failure of said functional lane.

In the example embodiment shown, Tx BIST unit 130 is coupled to receive status information from a PMC agent 120 during in-field operation of the 3D IC. For example, PMC agent 120 comprises any of various suitable types of hardware, firmware, and/or executing software which are operable to facilitate the management of power and/or performance characteristics of die 110 and/or other circuitry of system 100. In one such embodiment, PMC agent 120 comprises microcontroller circuitry which (for example) is adapted from any of various conventional power management control techniques.

The status information provided by PMC agent 120 specifies or otherwise indicates one or more operational states each for a respective one of multiple partitions of the 3D IC - e.g., wherein a first partition comprises source circuitry 112, and a second partition comprises sink circuitry 152. In one embodiment, the status information identifies one or more operational states on a per-partition level of granularity - e.g., wherein source circuitry 112 and sink circuitry 152 are individually identified as each being in a respective one of an idle state or a non-idle (or "active") state. In this particular context, "idle state" refers to an operational state wherein signal communication to or from a given partition is not currently taking place, and/or is expected to not take place - e.g., at least not for some threshold minimum period of time. By contrast, "active state" (or "non-idle" state) refers to an operational state wherein signal communication to or from a given partition is taking place, and/or is expected to take place - e.g., at least for some threshold minimum period of time.

In some embodiments, Rx BIST unit 170 is similarly coupled to receive the same (or related) status information - e.g., from a PMC agent 160 during in-field operation of the 3D IC. In the example embodiment shown, die 110 comprises PMC agent 120, and die 150 comprises Rx BIST unit 170. However, in an alternative embodiment, PMC agent 120 is external to die 110 and/or PMC agent 160 is external to die 150. Additionally or alternatively, one of PMC agent 120 or PMC agent 160 provides status information to the other of PMC agent 120 or PMC agent 160 - e.g., for relaying of said status information to a corresponding one of Tx BIST unit 130 or Rx BIST unit 170. In still another embodiment, Tx BIST unit 130 and Rx BIST unit 170 receive status information from the same PMC agent - e.g., wherein system 100 omits one of PMC agents 120, 160.

Based on status information provided by power management logic - such as that of PMC agent 120 and/or PMC agent 160 - Tx BIST unit 130 and PMC agent 160 variously detect the occurrence of one or more conditions which (for example) are to be a basis for lane test operations and/or a basis for lane repair operations. For example, Tx BIST unit 130 and PMC agent 160 variously detect, based on status information from PMC agent 120 and PMC agent 160 (respectively), a first condition wherein the first partition (comprising source circuitry 112) and the second partition (comprising sink circuitry 152) are each in a respective idle state.

In some embodiments, Tx BIST unit 130 and/or Rx BIST unit 170 further generate, receive or otherwise identify performance information which determines, at least in part, whether a lane repair is to be performed during the first condition. For example, PMC agent 120 (or any of various other suitable PMC resources) programs or otherwise configures one or more registers of Tx BIST unit 130, such as the illustrative configuration register(s) 132 shown, with information to facilitate lane testing. For example, such information describes a lane test which is to be performed - e.g., by specifying or otherwise identifying a duration of the lane test, a lane which is to be tested, a test signature (or other suitable test information) which is to be communicated via the lane under test, or the like. In some embodiments, configuration register(s) 132 further function as a repository of a result of a given lane test. Similarly, PMC agent 160 (or any of various other suitable PMC resources) programs or otherwise configures one or more registers of Rx BIST unit 170, such as the illustrative configuration register(s) 172 shown, with information such as that provided to configuration register(s) 132.

In one such embodiment, performance information is generated as a result of a lane test which (for example) is performed based on the detection of the first condition. For example, such a lane test comprises Tx BIST unit 130 transmitting test information via the first lane (that is, a lane under test) while said first lane is not being used by source circuitry 112 and sink circuitry 152. The Rx BIST unit 170 performs operations to determine whether a value (if any), received via the first lane during the lane test, matches some predetermined reference value, such as an originally defined value of the test information. Where a lane test detects a failure of a given functional lane to communicate such test information (or to satisfy some other performance criteria), Tx BIST unit 130 and Rx BIST unit 170 perform lane repair operations to substitute the functional lane in question with a repair lane for communications between die 110 and die 150.

In the example embodiment shown, mode circuitry 140 is coupled to Tx BIST unit 130, and is further coupled between source circuitry 112 and the hardware interface which comprises conductive contacts 114 and conductive contacts 116. Mode circuitry 140 comprises any of various combinations of switches, multiplexers and/or other suitable circuit structures which are operable - e.g., responsive to a controller 138 of Tx BIST unit 130 - to selectively enable or disable one or more conductive paths each between a respective input from source circuitry 112 and a respective one of conductive contacts 114, 116. Furthermore, mode circuitry 180 is coupled to Rx BIST unit 170, and is further coupled between sink circuitry 152 and the hardware interface which comprises conductive contacts 154 and conductive contacts 156. Mode circuitry 180 is operable - e.g., responsive to a controller 178 of Rx BIST unit 170 - to selectively enable or disable one or more conductive paths each between a respective input from sink circuitry 152 and a respective one of conductive contacts 154, 156.

In another embodiment, Tx BIST unit 130 and Rx BIST unit 170 perform a lane repair based on information which is received from one or more sensors (not shown) which are coupled to monitor one or more characteristics of communication via a functional lane. For example, in some embodiments, system 100 further comprises one or more sensors (included in or coupled to one or both of PMC agents 120, 160) which provide sensor information that specifies or otherwise indicates, to Tx BIST unit 130 and/or Rx BIST unit 170, one or more performance metrics including, but not limited to, a setup time which is needed to communicate information via the first lane.

In an illustrative scenario according to one embodiment, Tx BIST unit 130 and/or Rx BIST unit 170 detect, based on such performance information, that the setup time (or other such performance metric) has failed to satisfy some threshold condition. Based on such a failure, lane repair operations are performed to substitute the first lane with a repair lane for communications between die 110 and die 150. For example, such lane repair operations comprise controllers 138, 178 variously signaling mode circuitry 140 and mode circuitry 180 (respectively) to selectively enable or disable various signal paths by which source circuitry 112 and sink circuitry 152 are to participate in communications via the respective hardware interfaces of dice 110, 150.

Some embodiments variously adapt circuit structures which facilitate other lane testing and/or lane repair operations which, according to conventional techniques, are performed with an external test unit - e.g., prior to in-field operation of system 100 (for example, during semiconductor fabrication, packaging, assembly and/or any of various other stages). For example, some embodiments incorporate the use of any of various interconnect structures which are used in conventional lane test operations and/or lane repair operations. By way of illustration and not limitation, die 110 further comprises interface circuitry 122 which is coupled to receive status information, configuration information, performance information, or the like, from PMC agent 120, and to provide such information to Tx BIST unit 130 via a bus 124 which (for example) is compatible with any of various conventional test bus standards. In one such embodiment, the test bus standard is one developed by the Joint Test Action Group - e.g., wherein the test bus standard is defined or otherwise identified in the IEEE 1149.1 specification published on May 13, 2013 by the Institute of Electrical and Electronics Engineers of Piscataway, NJ, USA

Alternatively or in addition, die 150 further comprises interface circuitry 162 which is coupled to similarly receive information from PMC agent 160, and to provide such information to Rx BIST unit 170 via a bus 164 which is compatible with such a test bus standard. In some embodiments, interface circuitry 122 and/or interface circuitry 162 provide functionality to convert, reformat or otherwise process information to variously accommodate communication via busses 124, 164 - e.g., by converting the information from a format which enables communication via a PMC protocol bus to another format which enables communication via a JTAG protocol bus.

In one such embodiment, interface circuitry 122, or interface circuitry 162, is further coupled to another test bus (not shown) which is an artifact of structures which were used in conventional lane testing prior to in-field use of system 100. For example, such conventional lane testing is performed while system 100 (or at least one or more components thereof) is coupled, via a test access point (TAP), to an external test unit which is subsequently decoupled from any or all components of system 100. In one such embodiment, interface circuitry 122 comprises multiplexer circuitry to select between coupling bus 124 to PMC agent 120 and coupling bus 124 to an artifact test bus. Alternatively or in addition, interface circuitry 162 comprises multiplexer circuitry to select between coupling bus 164 to PMC agent 160 and coupling bus 164 to an artifact test bus.

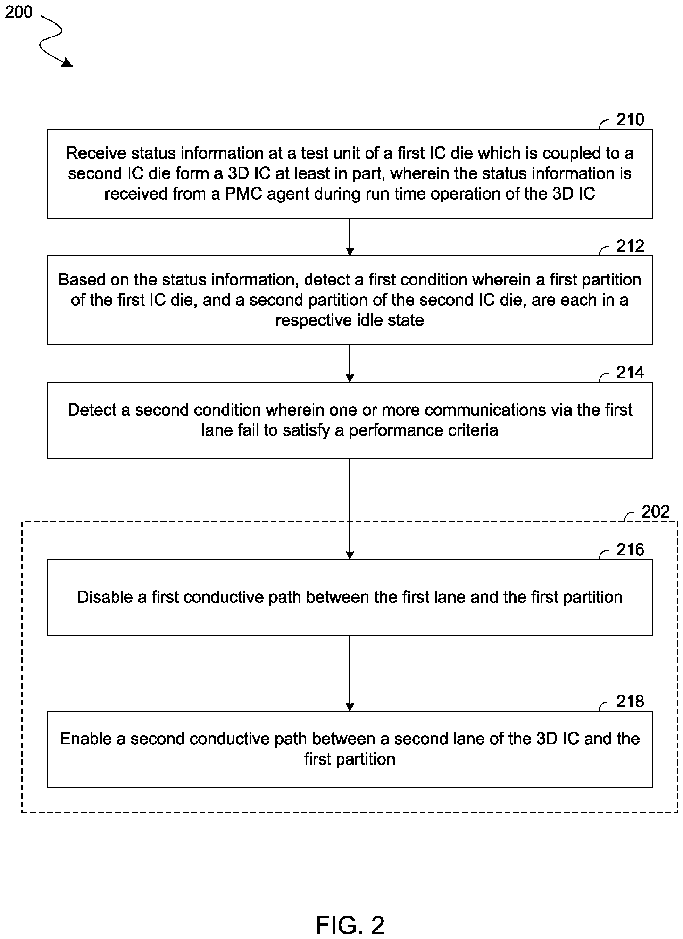

FIG. 2 shows features of a method 200 to perform in-field operations with a 3D IC according to an embodiment. Operations such as those of method 200 are performed, for example, with some or all of system 100. As shown in FIG. 2, method 200 comprises (at 210) receiving, at a test unit of a first IC die, status information from a PMC agent. The first IC die and a second IC die are coupled to form some or all of a 3D IC, wherein the test unit receives the status information during in-field operation of the 3D IC. In this context, "in-field operation" refers to any of various operations other than those which are merely for performance evaluation of the 3D IC by an external test unit (if any) which is coupled directly or indirectly to the 3D IC. By way of illustration and not limitation, in-field operations of the 3D IC include, or are otherwise concurrent with, an execution of a sequence of instructions by one or more processors of the 3D IC. Alternatively or in addition, in-field operations of the 3D IC are performed while a system which includes the 3D IC is decoupled from any external test unit which would otherwise perform testing of the 3D IC.

In one embodiment, the receiving at 210 comprises Tx BIST unit 130 receiving from PMC agent 120 information which specifies or otherwise indicates - e.g., at a partition-specific level of granularity - which one or more of multiple partitions of the 3D IC are each currently in (or are expected to be in) a respective idle state. The multiple partitions are each to operate in a first clock domain, for example. In some embodiments, the receiving at 210 additionally or alternatively comprises Rx BIST unit 170 receiving information from PMC agent 160 (for example).

In various embodiments, interface circuitry (such as interface circuitry 122) is coupled between the PMC agent and the test unit, wherein the interface circuitry provides the status information to the test unit via a bus which is compatible with a test bus standard. In one such embodiment, the test bus standard is identified in an Institute of Electrical and Electronics Engineers (IEEE) 1149.1 specification.

Based on the status information which is received at 210, method 200 (at 212) detects a first condition wherein a first partition of the first IC die, and a second partition of the second IC die, are each in a respective idle state. In some embodiments, the 3D IC comprises a first lane which is coupled to enable communication between the first partition and the second partition. In one such embodiment, the test unit is a first test unit, wherein multiple partitions of the 3D IC (e.g., including the first partition and the second partition) each correspond to a different respective one of multiple test units. For example, the multiple partitions comprise the first partition and the second partition, wherein, for each test unit of the multiple test units, one or more PMC agents are coupled to provide respective status information to the test unit.

In an illustrative scenario according to one embodiment, the first partition comprises a first signal source circuit (such as source circuitry 112) of the first IC die, and the second partition comprises a first signal sink circuit (such as sink circuitry 152) of the second IC die. In one such embodiment, a third partition of the 3D IC comprises a second signal source circuit of the second IC die, wherein a fourth partition of the 3D IC comprises a second signal sink circuit of the first IC die. The first condition is detected at 212, for example, while one or more other partitions (e.g., including the above-described third partition and the fourth partition) are each in a respective active state, although some embodiments are not limited in this regard.

Method 200 further comprises (at 214) detecting a second condition wherein one or more communications via the first lane fail to satisfy a performance criteria. For example, in various embodiments, method 200 comprises the test unit receiving test data from the PMC agent, performing a communication of the test data from the first IC die via the first lane. In one such embodiment, the second IC die (for example, a test unit thereof) generates a value based on the communication, wherein the second condition is detected at 214 based on the second IC die detecting a mismatch between the value and a reference value.

In various other embodiments, method 200 comprises the test unit receiving performance information from a sensor which is coupled to snoop or otherwise detect one or more characteristics of communication via the first lane. In one such embodiment, detecting the second condition at 214 comprises identifying, based on the performance information, a failure of a performance metric to satisfy a threshold condition, wherein the performance metric is based on one or more communications via the first lane. For example, the performance metric is a setup time (or a setup time margin), in some embodiments.

Method 200 further comprises operations 202 which are performed based on the first condition and the second condition - e.g., wherein operations 202 are performed during the first condition based on a failure of a lane test or based on a sensor detecting a failure of the first lane to satisfy a threshold for a performance metric. For example, operations 202 comprise (at 216) disabling a first conductive path between the first lane and the first partition. Furthermore, operations 202 comprise (at 218) enabling a second conductive path between a second lane (that is, a repair lane) of the 3D IC and the first partition or the second partition. In one example embodiment, operations 202 comprise controller 138 and controller 178 variously operating mode circuitry 140 and mode circuitry 180 to switchedly decouple one of lanes 102 from source circuitry 112 and sink circuitry 152, and to switchedly couple one of repair lanes 104 to source circuitry 112 and sink circuitry 152.

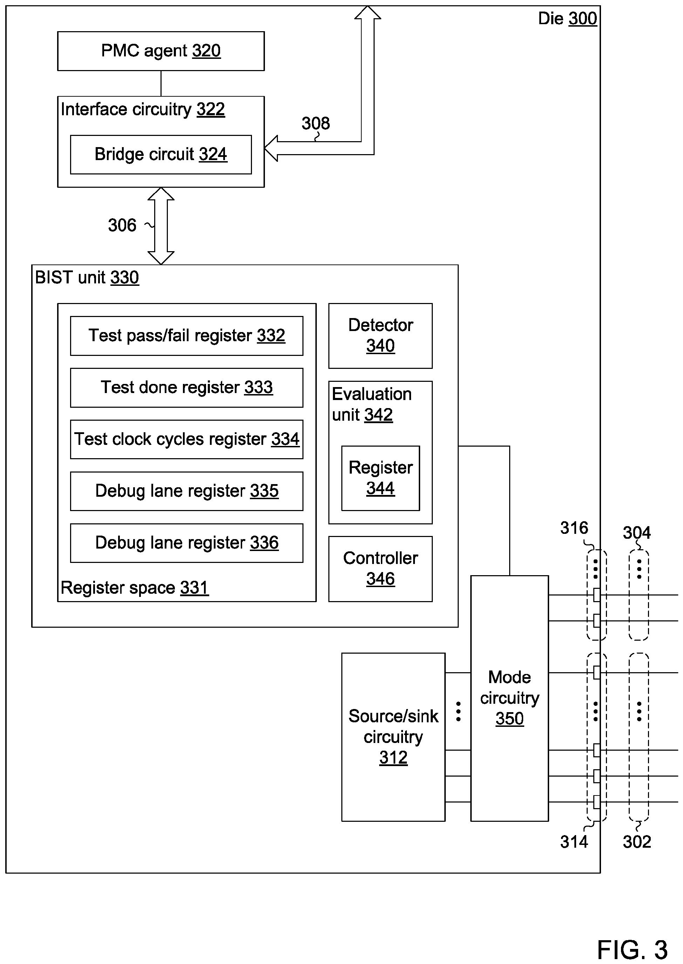

FIG. 3 shows features of a die 300 to selectively substitute a 3D IC lane with a repair 3D IC lane according to an embodiment. The die 300 illustrates one example of an embodiment wherein a 3D IC comprises a BIST unit (e.g., a Rx BIST or a Tx BIST) which is configurable to perform a lane test operation and to selectively perform a lane repair operation which substitutes one lane for another lane which fails to satisfy a communication performance criteria. In various embodiments, die 300 provides functionality such as that of system 100 - e.g., wherein one or more operations of method 200 are performed with die 300.

As shown in FIG. 3, a hardware interface of die 300 facilitates coupling to another die (not shown). For example, conductive contacts 314 of the hardware interface facilitate inter-die communications each with a respective one of functional lanes 302 - e.g., wherein other conductive contacts 316 of the hardware interface are available to alternatively facilitate inter-die communications each with a respective one of repair lanes 304.

In various embodiments, die 300 provides functionality similar to that of one of dice 110, 150. For example, source/sink circuitry 312 of die 300 provides functionality of source circuitry 112 or sink circuitry 152 - e.g., wherein mode circuitry 350 of die 300 provides functionality of mode circuitry 140 or mode circuitry 180, and wherein BIST unit 330 of die 300 provides functionality of Tx BIST unit 130 or Rx BIST unit 170. In one such embodiment, a PMC agent 320 and interface circuitry 322 of die 300 correspond functionally to PMC agent 120 and interface circuitry 122 (respectively). Although some embodiments are not limited in this regard, interface circuitry 322 is coupled to BIST unit 330 via a bus 306 which (for example) is compatible with a test bus standard such as on identified in an IEEE 1149.1 specification. In one such embodiment, interface circuitry 322 comprises a bridge circuit 324 which facilitates selective coupling of BIST unit 330 to either of PMC agent 320 or another bus 308 which, in an embodiment, is also compatible with the test standard. For example, bus 308 is used to communicate test information with an external test unit (not shown) - e.g., to facilitate lane testing, according to conventional techniques, during a fabrication packaging or other stage which is prior to in-field use of die 300 with one or more other dies.

In the example embodiment shown, a register space 331 of BIST unit 330 is configured to receive, update, or otherwise provide information - e.g., comprising one or more test parameters - which determines at least in part an in-field testing (and, for example, repair) of a given functional lane. By way of illustration and not limitation, a "test pass/fail" register 332 operates as a repository of information which specifies or otherwise indicates whether (or not) a given functional lane - or group of functional lanes - under test has passed a lane test under consideration. Alternatively or in addition, a "test done" register 333 operates as a repository of information which specifies or otherwise indicates whether a given lane test is has been completed (for example, by indicating whether any one or more lane tests are currently pending). Alternatively or in addition, a "test clock cycles" register 334 operates as a repository of information which specifies or otherwise indicates a length of time - e.g., in clock cycles - that is needed to accommodate a lane test. In one such embodiment, the test clock cycles register 334 identifies a number of clock cycles needed to accommodate a communication of signature data (or other suitable test information) as part of such a lane test.

In some embodiments, register space 331 additionally or alternatively comprises at least one register (referred to herein as a "debug lane register") which is to identify a functional lane which has been detected as failing to satisfy a performance criteria. In one such embodiment, this identification determines, at least in part, whether said functional lane is to be substituted with a repair lane. By way of illustration and not limitation, a debug lane register 335 of register space 331 operates as a repository of an identifier of a functional lane (if any) which has been - or it to be - substituted with a first repair lane. In various embodiments, a total number of debug registers in register space 331 is equal to a total number of conductive contacts 316 which are each to facilitate communication via a different respective one of repair lanes 304. For example, in one such embodiment, another debug lane register 336 of register space 331 operates as a repository of an identifier of another functional lane (if any) which has been - or it to be - substituted with a second repair lane. In some embodiments, one or more registers of register space 331 are programmed or otherwise configured - e.g., by PMC agent 320 or other suitable logic - to facilitate lane testing and/or lane repair functionality which is performed with other logic of BIST unit 330.

By way of illustration and not limitation, a detector 340 of BIST unit 330 is operable to detect a condition (such as the first condition which is detected at 212 of method 200) wherein a first partition and a second partition of a 3D IC - which comprises circuitry of die 300 - are each in a respective idle state. In one example embodiment, the first partition includes source/sink circuitry 312 - e.g., wherein the second partition comprises corresponding signal source (or signal sink) circuitry of another die which is coupled to communicate with source/sink circuitry 312 via mode circuitry 350 and one or more of lanes 302.

In one such embodiment, an evaluation unit 342 of BIST unit 330, which is coupled to detector 340, is operable to detect another condition (such as the second condition which is detected at 214 of method 200) wherein communication by a given functional lane fails to satisfy a performance criteria. For example, the second condition is detected as a result of a lane test operation which evaluation unit 342 participates in during the first condition. In an illustrative scenario according to one embodiment, BIST unit 330 is a Tx BIST unit, wherein a register 344 of evaluation unit 342 is a linear feedback shift register (LFSR), or other suitable circuitry, to function as a repository of one or more test patterns that are received from PMC agent 320. In one such embodiment, during a lane test, some or all of the one or more test patterns are communicated, via a functional lane which is under test, from evaluation unit 342 to a corresponding Rx BIST unit of another die (not shown).

In an alternative embodiment, BIST unit 330 is a Rx BIST unit - e.g., wherein evaluation unit 342 instead is coupled to receive one or more test patterns during a lane test. In one such embodiment, register 344 is a multiple input signature register (MISR), or other suitable circuitry, which is available to receive test information, if any, from a Tx BIST unit of another die (assuming the link under test is capable of communicating test information to die 300). In an embodiment where BIST unit 330 is a Rx BIST unit, evaluation unit 342 performs operations to generate a signature value based on the received test information (if any), and to compare said signature value to a predetermined reference ("golden") signature value. Based on such a comparison, evaluation unit 342 determines whether the lane under test is defective and, if so, how a lane repair operation is to substitute the lane under test with an alternative one of repair lanes 304.

By way of illustration and not limitation, a controller 346 of BIST unit 330 is operable to selectively perform a lane repair operation based on the first condition and the second condition. Mode circuitry 350 comprises one or more switches, multiplexers and/or other suitable circuit structures which, responsive to controller 346, to selectively enable or disable one or more conductive paths each between a respective source/sink circuitry 312 and a respective one of conductive contacts 314, 316.

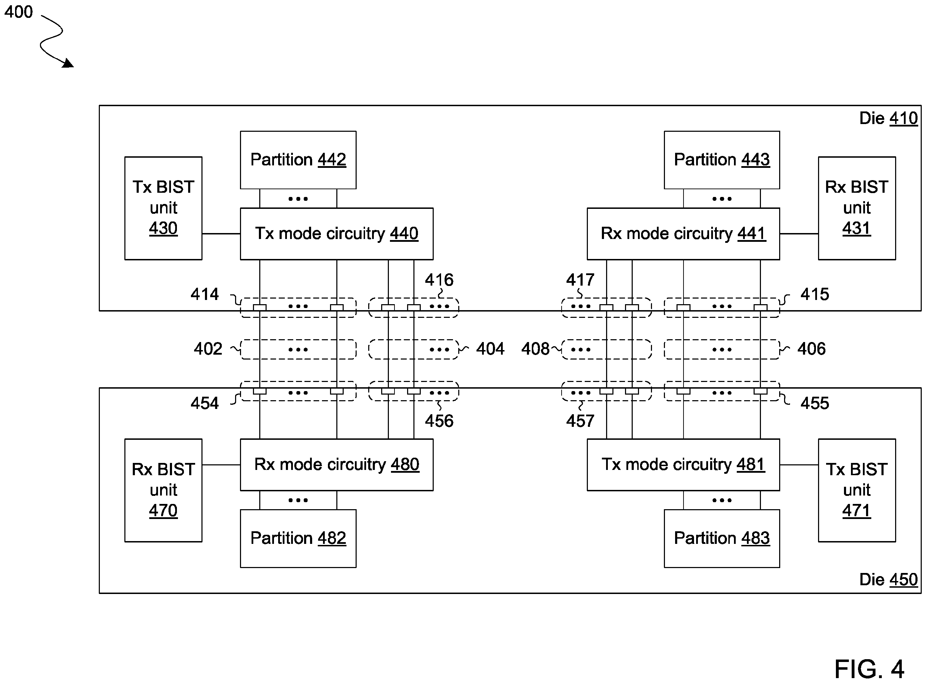

FIG. 4 shows features of a system 400 to perform in-field lane repair in a multi-partition clock domain according to an embodiment. The system 400 illustrates one example of an embodiment wherein in-field lane testing is performed based on the respective idleness states of multiple partitions of a 3D IC. In various embodiments, system 400 provides functionality such as that of system 100 or die 300 - e.g., wherein one or more operations of method 200 are performed with system 400.

As shown in FIG. 4, system 400 comprises dice 410, 450 which are coupled to each other to form some or all of a 3D IC which comprises functional lanes (such as the illustrative lanes 402 and lanes 406 shown) and repair lanes (such as the illustrative repair lanes 404 and repair lanes 408 shown). Die 410 comprises both a first hardware interface by which signals are transmitted to die 450, and a second hardware interface by which signals are received from die 450. For example, die 450 comprises both a third hardware interface by which signals are received from the first hardware interface, and a fourth hardware interface by which signals are transmitted to the second hardware interface.

In the example embodiment shown, conductive contacts 414 of the first hardware interface are variously coupled, via lanes 402, each to a different respective one of conductive contacts 454 of the third hardware interface - e.g., wherein conductive contacts 416 of the first hardware interface are variously coupled, via repair lanes 404, each to a respective one of conductive contacts 456 of the third hardware interface. Similarly, conductive contacts 415 of the second hardware interface are variously coupled, via lanes 406, each to a different respective one of conductive contacts 455 of the fourth hardware interface - e.g., wherein conductive contacts 417 of the second hardware interface are variously coupled, via repair lanes 408, each to a respective one of conductive contacts 457 of the fourth hardware interface.

In various embodiments, dice 410, 450 variously provide functionality similar to that of dice 110, 150 - e.g., wherein lanes 402 correspond functionally to lanes 102, and wherein repair lanes 404 correspond functionally to repair lanes 104. In one such embodiment, a partition 442, Tx mode circuitry 440, and a Tx BIST unit 430 of die 410 provide functionality such as that of source circuitry 112, mode circuitry 140, and Tx BIST unit 130 (respectively) - e.g., wherein a partition 482, Rx mode circuitry 480, and a Rx BIST unit 470 of die 450 provide functionality such as that of sink circuitry 152, mode circuitry 180, and Rx BIST unit 170 (respectively). Alternatively or in addition, a partition 483, Tx mode circuitry 481, and a Tx BIST unit 481 of die 450 provide functionality such as that of source circuitry 112, mode circuitry 140, and Tx BIST unit 130 (respectively) - e.g., wherein a partition 443, mode circuitry 441, and a Rx BIST unit 431 of die 410 provide functionality such as that of sink circuitry 152, mode circuitry 180, and Rx BIST unit 170 (respectively).

In various embodiments, partitions 442, 482 are to operate in a first clock domain, wherein BIST units 430, 470 are operable to perform first in-field lane testing and/or a first lane repair - e.g., to substitute one of lanes 402 with one of repair lanes 404 - while partitions 442, 482 are each in a respective idle state. In an illustrative scenario according to one embodiment, partitions 443, 483 are also to operate in the same first clock domain, wherein BIST units 430, 470 to perform first in-field lane testing and/or a first lane repair while one or each of partitions 443, 483 is in a respective active (non-idle) state. Additionally or alternatively, BIST units 431, 471 are operable to perform second in-field lane testing and/or a second lane repair - e.g., to substitute one of lanes 406 with one of repair lanes 408 - while one or each of partitions 442, 482 is in a respective active (non-idle) state. In an alternative embodiment, partitions 442, 482 are to operate in a first clock domain, and partitions 443, 483 are to operate in a second clock domain - e.g., wherein lane test and/or lane repair operations by BIST units 430, 470 are performed independent of lane test and/or lane repair operations by BIST units 431, 471.

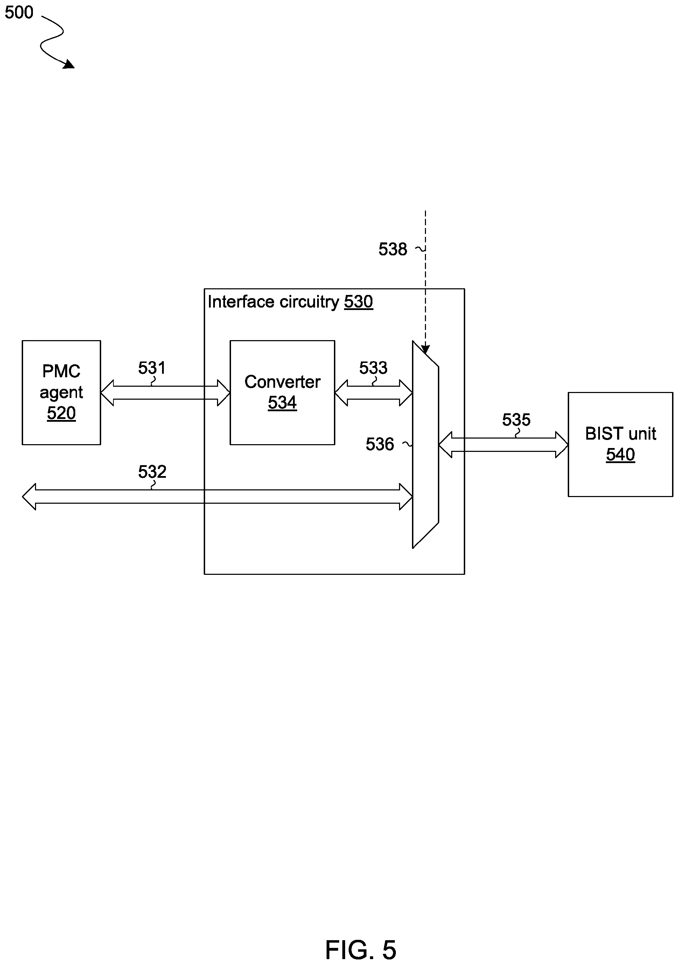

FIG. 5 shows features of a die 500 to configure in-field lane repair functionality of a built-in self-test unit according to an embodiment. The die 500 illustrates one example of an embodiment wherein a BIST unit supports in-field lane test and repair, and is further coupled to support circuit testing by an external test unit. In various embodiments, die 500 provides functionality such as that of die 110 or die 150 - e.g., wherein one or more operations of method 200 are performed with die 500.

As shown in FIG. 5, die 500 comprises a PMC agent 520, interface circuitry 530, and a BIST unit 540 which, for example, correspond functionally to PMC agent 120, interface circuitry 122, and Tx BIST unit 130 (respectively). Interface circuitry 530 comprises a converter 534 and a multiplexer (MUX) 536, wherein converter 534 is coupled to receive status information, performance information, or the like from PMC agent 520 via a bus 531. Converter 534 comprises circuitry to reformat or otherwise convert such information for communication to MUX 536 via another bus (e.g., the illustrative JTAG bus 533 shown) which is compatible with a test bus standard, such as one which is identified in an IEEE 1149.1 specification.

In some embodiments, MUX 536 is coupled, in a bridge circuit configuration, with JTAG bus 533 and other JTAG busses 532, 535 which are also compatible with the same test bus standard. In one such embodiment, JTAG bus 532 is operable used to communicate test information with an external test unit via a test access point (not shown) of die 500 - e.g., to facilitate testing which, according to conventional techniques, takes place during a fabrication, packaging or other stage which is prior to in-field use of die 500. By contrast, in some embodiments, in-field operation of die 500 - e.g., while die 500 is coupled with one or more other dies to form a 3D IC - takes place while an input for control signal 538 is tied to a fixed voltage, which sets MUX 536 to only pass signals between JTAG bus 533 and JTAG bus 535. In providing interface circuitry 530, some embodiments variously facilitate in-field test functionality by expanding the functionality of, or otherwise adapting, circuitry is used for conventional circuit testing with an external test unit.

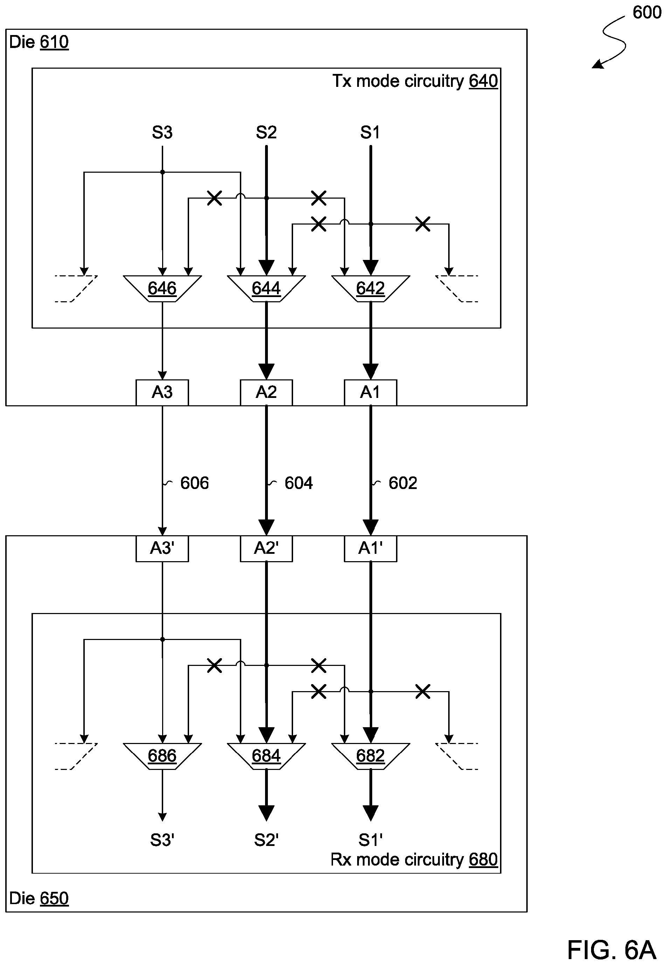

FIG. 6A shows features of a system 600 to configure a mode of operation which facilitates in-field lane repair according to an embodiment. The system 600 illustrates one example of an embodiment wherein any of various modes of operation are configurable to substitute a functional lane of a 3D IC with a repair lane. In various embodiments, system 600 provides functionality such as that of system 100 - e.g., wherein one or more operations of method 200 are performed with system 600.

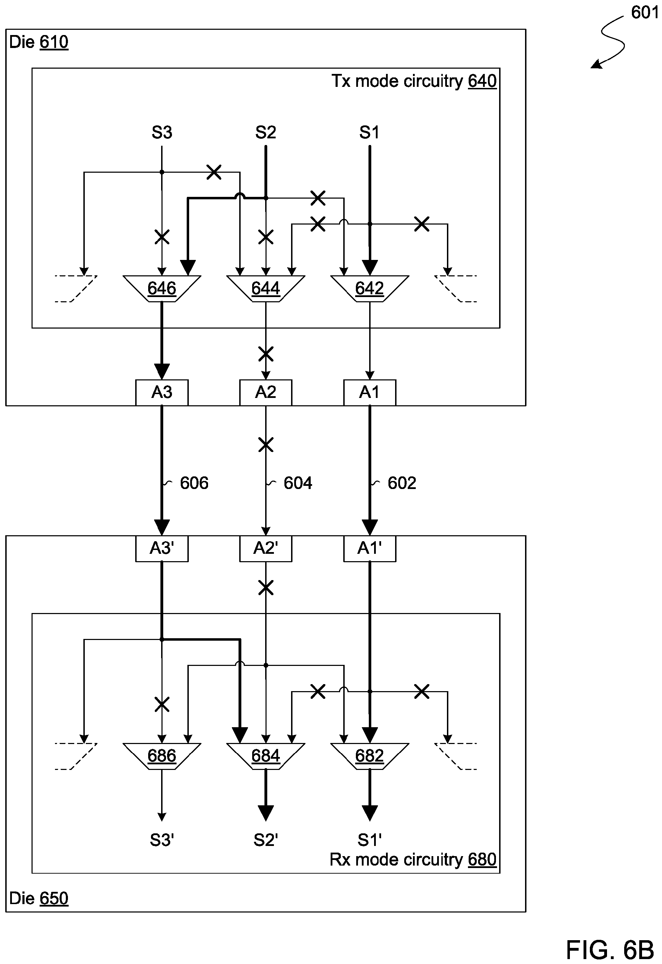

As shown in FIG. 6, system 600 comprises dice 610, 650 which are coupled to each other in a 3D IC arrangement which comprises functional lanes 602, 604, and a repair lane 606. A hardware interface of die 610 comprises conductive contacts A1, A2, A3, wherein a hardware interface of die 650 similarly comprises conductive contacts A1', A2', A3'. In the example embodiment shown, conductive contacts A1, A2, A3 are coupled, via lanes 602, 604, 606 (respectively), to conductive contacts A1', A2', A3'. In various embodiments, dice 610, 650 variously provide functionality similar to that of dice 110, 150 - e.g., wherein Tx mode circuitry 640 of die 610 corresponds functionally to mode circuitry 140, and wherein Rx mode circuitry 680 of die 650 corresponds functionally to mode circuitry 180.

FIG. 6A shows a mode of system 600 wherein Tx mode circuitry 640 and Rx mode circuitry 680 are variously configured in a first mode to enable respective communications via functional lanes 602, 604. More particularly, Tx mode circuitry 640 comprises multiplexers 642, 644, 646, and Rx mode circuitry 680 comprises multiplexers 682, 684, 686. In the first mode, MUX 642 is configured to pass a signal S1 to MUX 682 via lane 602, while MUX 644 is configured to pass a signal S2 to MUX 684 via lane 604. Although MUX 646 is capable of passing a signal S3 to MUX 686 via repair lane 606, no such signal S3 is generated during the first mode, in some embodiments. In another embodiment, lane 606 is a functional lane which does communicate a signal S3 - e.g., where some other lane (not shown) is to be available as a substitute for lane 606, and wherein lane 606 is available to be used as a repair lane for lane 604.

By contrast, FIG. 6B shows a second mode 601 of device 600, wherein communication via repair lane 606 is substituted for communication via lane 604. In FIGs. 6A, 6B, thick lines are used to represent signal paths which are selected by MUXs, and 'X' symbols are used to indicate signal paths which are not selected by a given MUX. In the second mode, MUX 646 and MUX 684 are configured to pass a signal S2 between dies 610, 650 via lane 606, wherein communication via lane 604 is thereby disabled.

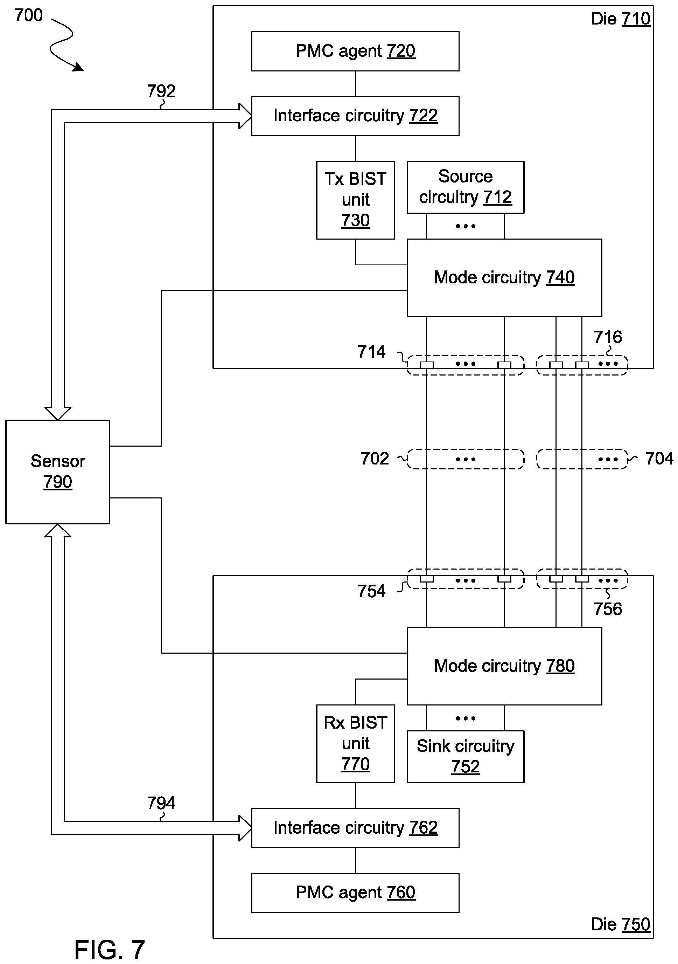

FIG. 7 shows features of a system 700 to facilitate predictive in-field lane repair functionality according to an embodiment. System 700 illustrates one example of an embodiment wherein lane repair operations are performed based on a determination that, according to some predetermined criteria, a functional lane is expected to fail in the future (even though, for example, the functional lane is currently able to successfully communicate a signal between dies which form some or all of a 3D IC). In various embodiments, system 700 provides functionality such as that of system 100, die 300, system 400, die 500 or system 600 - e.g., wherein one or more operations of method 200 are performed with system 700.

As shown in FIG. 7, system 700 comprises dice 710, 750 which are coupled to each other to form, at least in part, a 3D IC which comprises one or more functional lanes (such as the illustrative lanes 702 shown) and one or more repair lanes (such as the illustrative repair lanes 704 shown). A hardware interface of die 710 comprises conductive contacts 714 and conductive contacts 716, wherein a hardware interface of die 750 similarly comprises conductive contacts 754 and conductive contacts 756. In the example embodiment shown, conductive contacts 714 are variously coupled, via lanes 702, each to a different respective one of conductive contacts 754 of die 750 - e.g., wherein conductive contacts 716 are variously coupled, via repair lanes 704, each to a respective one of conductive contacts 756.

In various embodiments, dice 710, 750 variously provide functionality similar to that of dice 110, 150 - e.g., wherein lanes 702 correspond functionally to lanes 102, and wherein repair lanes 704 correspond functionally to repair lanes 104. In one such embodiment, source circuitry 712, mode circuitry 740, and a Tx BIST unit 730 of die 710 correspond functionally to source circuitry 112, mode circuitry 140, and Tx BIST unit 130 (respectively) - e.g., wherein a PMC agent 720, and interface circuitry 722 of die 710 correspond functionally to PMC agent 120, and interface circuitry 122 (respectively). Alternatively or in addition, sink circuitry 752, mode circuitry 780, and a Rx BIST unit 770 of die 750 correspond functionally to sink circuitry 152, mode circuitry 180, and Rx BIST unit 170 (respectively) - e.g., wherein a PMC agent 760, and interface circuitry 762 of die 750 correspond functionally to a PMC agent 160, and interface circuitry 162 (respectively).

In an embodiment, the performance of one or more functional lanes is monitored, during in-field operation of system 700, using one or more sensors (e.g., such as the illustrative sensor 790 shown). For example, sensor 790 is coupled to monitor a sensitivity of a given functional lane. By way of illustration and not limitation, "sensitivity" in this context is indicated by one or more characteristics including, but not limited to, a relatively tight setup timing margin - e.g., as compared to threshold timing margin which (for example) is determined during a design/manufacturing phase or during in-field deployment. In some embodiments, sensor 790 provides intelligent sensor functionality which dynamically adjusts one or more lane performance threshold values - e.g., using any of various run-time analytical techniques.

In some embodiments, functional lanes are allocated each to a respective sensor - e.g., wherein such allocation is performed dynamically in-field. A given one sensor (such as sensor 790) includes or otherwise has access to threshold information to be used as a reference for determining when communication via a given one of lanes 702 is outside of a performance margin. Furthermore, sensor 790 is coupled (for example, via mode circuitry 740 and mode circuitry 780) to snoop or otherwise detect characteristics of signal communications which are performed with lanes 702.

In an illustrative scenario according to one embodiment, sensor 790 detects the reaching or exceeding of a threshold timing margin (or other) limit by a particular one of lanes 702. Based on such detection, sensor 790 programs or otherwise configures a microcontroller, firmware, or other suitable resource of Tx BIST unit 730 (and, for example, a similar resource of Rx BIST unit 770) - e.g., by setting a repair bit of a configuration register. In the example embodiment shown, sensor 790 sends signals to Tx BIST unit 730 via a bus 792 and interface circuitry 722, and/or sends signals to Rx BIST unit 770 via a bus 794 and interface circuitry 762.

In one example embodiment, a size of a repair register is equal to (or otherwise corresponds to) a number of lanes which are under the control of a particular BIST unit. For example, in one embodiment, a controller of a BIST unit is coupled to selectively configure any often lanes, wherein a repair register of said BIST unit has a 10-bit width. In one example scenario for such an embodiment, sensor 790 detects marginal performance of a lane 2 - e.g., wherein sensor 790 detects a hit of a threshold performance limit, and wherein Tx BIST unit 730 reads, receives or otherwise accesses an identifier of that same lane number 2 based on an interrupt which is sent by sensor 790. Based on the detecting of the threshold hit event, Tx BIST unit 730 sets a bit 2 in the repair register which corresponds to the marginal lane 2. Subsequently, a controller of Tx BIST unit 730 selectively asserts or deasserts the respective select lines of various repair muxes, in mode circuitry 740. Similarly, a controller of Rx BIST unit 770 selectively asserts or deasserts the respective select lines of various repair muxes, in mode circuitry 780. This selective configuring of mode circuitry 740 and mode circuitry 780 implements a lane repair which substitutes the marginal lane 2 with one of repair lanes 704.

In an illustrative scenario according to one embodiment, sensor 790 is a timing margin sensor (TMS) that monitors the setup margin of a corresponding timing path. By way of illustration and not limitation, functional lanes 702 are eight lanes, and repair lanes 704 are two lanes, wherein three of the functional lanes are designed to operate with a timing margin (e.g., +15 picoseconds) which is relatively tight, as compared to that for the other five functional lanes. In one such embodiment, sensor 790 performs monitoring of the three functional lanes based on a threshold limit (e.g., 5 picoseconds) which, for example, is based on design time modeling, runtime performance analysis, or the like. In one example scenario, two of the three lanes are detected by sensor 790 (and or other such sensors) each as reaching or exceeding of the threshold limit.

In response, sensor 790 sends respective interrupts to Tx BIST unit 730 and Rx BIST unit 770, which then read sensor information which identifies the two marginal lanes and/or other related information. Based on the detection of the two lanes' marginal performance, Tx BIST unit 730 and Rx BIST unit 770 each set a corresponding two bits of a respective repair register. Based on the setting of said bits, lane repair is performed by variously operating (for example, asserting or de-asserting) repair muxes of mode circuitry 740 and mode circuitry 780 to substitute the marginally performing functional lanes each with a respective one of repair lanes 704.

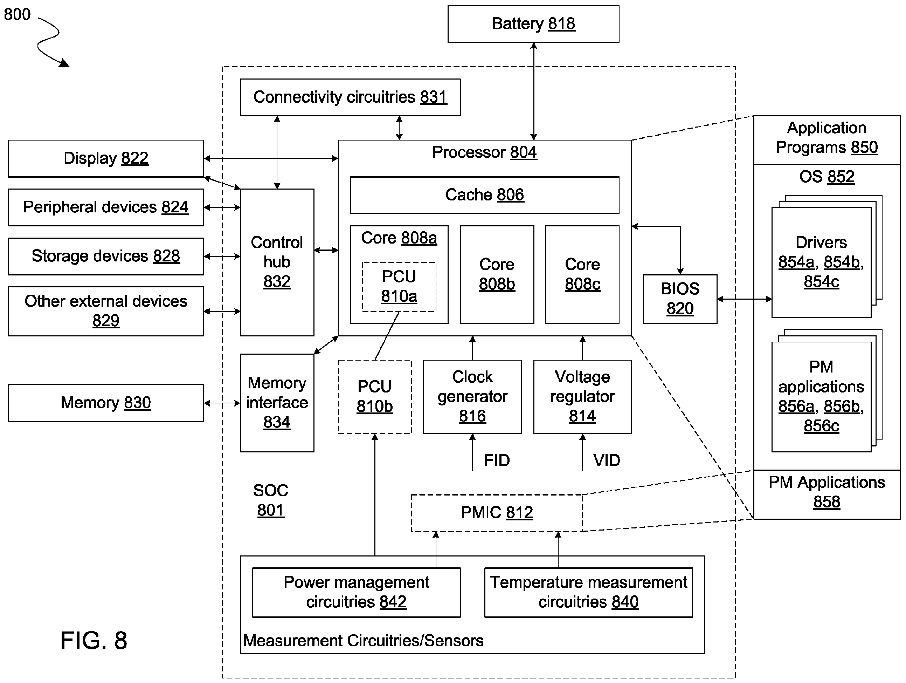

FIG. 8 illustrates a computer system or computing device 800 (also referred to as device 800) which supports in-field lane testing and repair for a 3D IC in accordance with some embodiments. It is pointed out that those elements of FIG. 8 having the same reference numbers (or names) as the elements of any other figure can operate or function in any manner similar to that described, but are not limited to such.

In some embodiments, device 800 represents an appropriate computing device, such as a computing tablet, a mobile phone or smart-phone, a laptop, a desktop, an Internet-of- Things (IOT) device, a server, a wearable device, a set-top box, a wireless-enabled e-reader, or the like. It will be understood that certain components are shown generally, and not all components of such a device are shown in device 800.

In an example, the device 800 comprises a SoC (System-on-Chip) 801. An example boundary of the SOC 801 is illustrated using dotted lines in FIG. 8, with some example components being illustrated to be included within SOC 801 - however, SOC 801 may include any appropriate components of device 800.

In some embodiments, device 800 includes processor 804. Processor 804 can include one or more physical devices, such as microprocessors, application processors, microcontrollers, programmable logic devices, processing cores, or other processing means. The processing operations performed by processor 804 include the execution of an operating platform or operating system on which applications and/or device functions are executed. The processing operations include operations related to I/O (input/output) with a human user or with other devices, operations related to power management, operations related to connecting computing device 800 to another device, and/or the like. The processing operations may also include operations related to audio I/O and/or display I/O.

In some embodiments, processor 804 includes multiple processing cores (also referred to as cores) 808a, 808b, 808c. Although merely three cores 808a, 808b, 808c are illustrated in FIG. 8, the processor 804 may include any other appropriate number of processing cores, e.g., tens, or even hundreds of processing cores. Processor cores 808a, 808b, 808c may be implemented on a single integrated circuit (IC) chip. Moreover, the chip may include one or more shared and/or private caches, buses or interconnections, graphics and/or memory controllers, or other components.

In some embodiments, processor 804 includes cache 806. In an example, sections of cache 806 may be dedicated to individual cores 808 (e.g., a first section of cache 806 dedicated to core 808a, a second section of cache 806 dedicated to core 808b, and so on). In an example, one or more sections of cache 806 may be shared among two or more of cores 808. Cache 806 may be split in different levels, e.g., level 1 (L1) cache, level 2 (L2) cache, level 3 (L3) cache, etc.

In some embodiments, a given processor core (e.g., core 808a) may include a fetch unit to fetch instructions (including instructions with conditional branches) for execution by the core 808a. The instructions may be fetched from any storage devices such as the memory 830. Processor core 808a may also include a decode unit to decode the fetched instruction. For example, the decode unit may decode the fetched instruction into a plurality of micro-operations. Processor core 808a may include a schedule unit to perform various operations associated with storing decoded instructions. For example, the schedule unit may hold data from the decode unit until the instructions are ready for dispatch, e.g., until all source values of a decoded instruction become available. In one embodiment, the schedule unit may schedule and/or issue (or dispatch) decoded instructions to an execution unit for execution.

The execution unit may execute the dispatched instructions after they are decoded (e.g., by the decode unit) and dispatched (e.g., by the schedule unit). In an embodiment, the execution unit may include more than one execution unit (such as an imaging computational unit, a graphics computational unit, a general-purpose computational unit, etc.). The execution unit may also perform various arithmetic operations such as addition, subtraction, multiplication, and/or division, and may include one or more an arithmetic logic units (ALUs). In an embodiment, a co-processor (not shown) may perform various arithmetic operations in conjunction with the execution unit.

Further, an execution unit may execute instructions out-of-order. Hence, processor core 808a (for example) may be an out-of-order processor core in one embodiment. Processor core 808a may also include a retirement unit. The retirement unit may retire executed instructions after they are committed. In an embodiment, retirement of the executed instructions may result in processor state being committed from the execution of the instructions, physical registers used by the instructions being de-allocated, etc. The processor core 808a may also include a bus unit to enable communication between components of the processor core 808a and other components via one or more buses. Processor core 808a may also include one or more registers to store data accessed by various components of the core 808a (such as values related to assigned app priorities and/or sub-system states (modes) association.

In some embodiments, device 800 comprises connectivity circuitries 831. For example, connectivity circuitries 831 includes hardware devices (e.g., wireless and/or wired connectors and communication hardware) and/or software components (e.g., drivers, protocol stacks), e.g., to enable device 800 to communicate with external devices. Device 800 may be separate from the external devices, such as other computing devices, wireless access points or base stations, etc.

In an example, connectivity circuitries 831 may include multiple different types of connectivity. To generalize, the connectivity circuitries 831 may include cellular connectivity circuitries, wireless connectivity circuitries, etc. Cellular connectivity circuitries of connectivity circuitries 831 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, 3rd Generation Partnership Project (3GPP) Universal Mobile Telecommunications Systems (UMTS) system or variations or derivatives, 3GPP Long-Term Evolution (LTE) system or variations or derivatives, 3GPP LTE-Advanced (LTE-A) system or variations or derivatives, Fifth Generation (5G) wireless system or variations or derivatives, 5G mobile networks system or variations or derivatives, 5G New Radio (NR) system or variations or derivatives, or other cellular service standards. Wireless connectivity circuitries (or wireless interface) of the connectivity circuitries 831 refers to wireless connectivity that is not cellular, and can include personal area networks (such as Bluetooth, Near Field, etc.), local area networks (such as Wi-Fi), and/or wide area networks (such as WiMax), and/or other wireless communication. In an example, connectivity circuitries 831 may include a network interface, such as a wired or wireless interface, e.g., so that a system embodiment may be incorporated into a wireless device, for example, cell phone or personal digital assistant.

In some embodiments, device 800 comprises control hub 832, which represents hardware devices and/or software components related to interaction with one or more I/O devices. For example, processor 804 may communicate with one or more of display 822, one or more peripheral devices 824, storage devices 828, one or more other external devices 829, etc., via control hub 832. Control hub 832 may be a chipset, a Platform Control Hub (PCH), and/or the like.

For example, control hub 832 illustrates one or more connection points for additional devices that connect to device 800, e.g., through which a user might interact with the system. For example, devices (e.g., devices 829) that can be attached to device 800 include microphone devices, speaker or stereo systems, audio devices, video systems or other display devices, keyboard or keypad devices, or other I/O devices for use with specific applications such as card readers or other devices.

As mentioned above, control hub 832 can interact with audio devices, display 822, etc. For example, input through a microphone or other audio device can provide input or commands for one or more applications or functions of device 800. Additionally, audio output can be provided instead of, or in addition to display output. In another example, if display 822 includes a touch screen, display 822 also acts as an input device, which can be at least partially managed by control hub 832. There can also be additional buttons or switches on computing device 800 to provide I/O functions managed by control hub 832. In one embodiment, control hub 832 manages devices such as accelerometers, cameras, light sensors or other environmental sensors, or other hardware that can be included in device 800. The input can be part of direct user interaction, as well as providing environmental input to the system to influence its operations (such as filtering for noise, adjusting displays for brightness detection, applying a flash for a camera, or other features).

In some embodiments, control hub 832 may couple to various devices using any appropriate communication protocol, e.g., PCIe (Peripheral Component Interconnect Express), USB (Universal Serial Bus), Thunderbolt, High Definition Multimedia Interface (HDMI), Firewire, etc.

In some embodiments, display 822 represents hardware (e.g., display devices) and software (e.g., drivers) components that provide a visual and/or tactile display for a user to interact with device 800. Display 822 may include a display interface, a display screen, and/or hardware device used to provide a display to a user. In some embodiments, display 822 includes a touch screen (or touch pad) device that provides both output and input to a user. In an example, display 822 may communicate directly with the processor 804. Display 822 can be one or more of an internal display device, as in a mobile electronic device or a laptop device or an external display device attached via a display interface (e.g., DisplayPort, etc.). In one embodiment display 822 can be a head mounted display (HMD) such as a stereoscopic display device for use in virtual reality (VR) applications or augmented reality (AR) applications.

In some embodiments and although not illustrated in the figure, in addition to (or instead of) processor 804, device 800 may include Graphics Processing Unit (GPU) comprising one or more graphics processing cores, which may control one or more aspects of displaying contents on display 822.

Control hub 832 (or platform controller hub) may include hardware interfaces and connectors, as well as software components (e.g., drivers, protocol stacks) to make peripheral connections, e.g., to peripheral devices 824.

It will be understood that device 800 could both be a peripheral device to other computing devices, as well as have peripheral devices connected to it. Device 800 may have a "docking" connector to connect to other computing devices for purposes such as managing (e.g., downloading and/or uploading, changing, synchronizing) content on device 800. Additionally, a docking connector can allow device 800 to connect to certain peripherals that allow computing device 800 to control content output, for example, to audiovisual or other systems.

In addition to a proprietary docking connector or other proprietary connection hardware, device 800 can make peripheral connections via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

In some embodiments, connectivity circuitries 831 may be coupled to control hub 832, e.g., in addition to, or instead of, being coupled directly to the processor 804. In some embodiments, display 822 may be coupled to control hub 832, e.g., in addition to, or instead of, being coupled directly to processor 804.

In some embodiments, device 800 comprises memory 830 coupled to processor 804 via memory interface 834. Memory 830 includes memory devices for storing information in device 800. Memory can include nonvolatile (state does not change if power to the memory device is interrupted) and/or volatile (state is indeterminate if power to the memory device is interrupted) memory devices. Memory device 830 can be a dynamic random access memory (DRAM) device, a static random access memory (SRAM) device, flash memory device, phase-change memory device, or some other memory device having suitable performance to serve as process memory. In one embodiment, memory 830 can operate as system memory for device 800, to store data and instructions for use when the one or more processors 804 executes an application or process. Memory 830 can store application data, user data, music, photos, documents, or other data, as well as system data (whether long-term or temporary) related to the execution of the applications and functions of device 800.

Elements of various embodiments and examples are also provided as a machine-readable medium (e.g., memory 830) for storing the computer-executable instructions (e.g., instructions to implement any other processes discussed herein). The machine-readable medium (e.g., memory 830) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

In some embodiments, device 800 comprises temperature measurement circuitries 840, e.g., for measuring temperature of various components of device 800. In an example, temperature measurement circuitries 840 may be embedded, or coupled or attached to various components, whose temperature are to be measured and monitored. For example, temperature measurement circuitries 840 may measure temperature of (or within) one or more of cores 808a, 808b, 808c, voltage regulator 814, memory 830, a mother-board of SOC 801, and/or any appropriate component of device 800.

In some embodiments, device 800 comprises power measurement circuitries 842, e.g., for measuring power consumed by one or more components of the device 800. In an example, in addition to, or instead of, measuring power, the power measurement circuitries 842 may measure voltage and/or current. In an example, the power measurement circuitries 842 may be embedded, or coupled or attached to various components, whose power, voltage, and/or current consumption are to be measured and monitored. For example, power measurement circuitries 842 may measure power, current and/or voltage supplied by one or more voltage regulators 814, power supplied to SOC 801, power supplied to device 800, power consumed by processor 804 (or any other component) of device 800, etc.

In some embodiments, device 800 comprises one or more voltage regulator circuitries, generally referred to as voltage regulator (VR) 814. VR 814 generates signals at appropriate voltage levels, which may be supplied to operate any appropriate components of the device 800. Merely as an example, VR 814 is illustrated to be supplying signals to processor 804 of device 800. In some embodiments, VR 814 receives one or more Voltage Identification (VID) signals, and generates the voltage signal at an appropriate level, based on the VID signals. Various type of VRs may be utilized for the VR 814. For example, VR 814 may include a "buck" VR, "boost" VR, a combination of buck and boost VRs, low dropout (LDO) regulators, switching DC-DC regulators, etc. Buck VR is generally used in power delivery applications in which an input voltage needs to be transformed to an output voltage in a ratio that is smaller than unity. Boost VR is generally used in power delivery applications in which an input voltage needs to be transformed to an output voltage in a ratio that is larger than unity. In some embodiments, each processor core has its own VR which is controlled by PCU 810a/b and/or PMIC 812. In some embodiments, each core has a network of distributed LDOs to provide efficient control for power management. The LDOs can be digital, analog, or a combination of digital or analog LDOs.

In some embodiments, device 800 comprises one or more clock generator circuitries, generally referred to as clock generator 816. Clock generator 816 generates clock signals at appropriate frequency levels, which may be supplied to any appropriate components of device 800. Merely as an example, clock generator 816 is illustrated to be supplying clock signals to processor 804 of device 800. In some embodiments, clock generator 816 receives one or more Frequency Identification (FID) signals, and generates the clock signals at an appropriate frequency, based on the FID signals.

In some embodiments, device 800 comprises battery 818 supplying power to various components of device 800. Merely as an example, battery 818 is illustrated to be supplying power to processor 804. Although not illustrated in the figures, device 800 may comprise a charging circuitry, e.g., to recharge the battery, based on Alternating Current (AC) power supply received from an AC adapter.

In some embodiments, device 800 comprises Power Control Unit (PCU) 810 (also referred to as Power Management Unit (PMU), Power Controller, etc.). In an example, some sections of PCU 810 may be implemented by one or more processing cores 808, and these sections of PCU 810 are symbolically illustrated using a dotted box and labelled PCU 810a. In an example, some other sections of PCU 810 may be implemented outside the processing cores 808, and these sections of PCU 810 are symbolically illustrated using a dotted box and labelled as PCU 810b. PCU 810 may implement various power management operations for device 800. PCU 810 may include hardware interfaces, hardware circuitries, connectors, registers, etc., as well as software components (e.g., drivers, protocol stacks), to implement various power management operations for device 800.

In some embodiments, device 800 comprises Power Management Integrated Circuit (PMIC) 812, e.g., to implement various power management operations for device 800. In some embodiments, PMIC 812 is a Reconfigurable Power Management ICs (RPMICs) and/or an IMVP (Intel^{®} Mobile Voltage Positioning). In an example, the PMIC is within an IC chip separate from processor 804. The may implement various power management operations for device 800. PMIC 812 may include hardware interfaces, hardware circuitries, connectors, registers, etc., as well as software components (e.g., drivers, protocol stacks), to implement various power management operations for device 800.

In an example, device 800 comprises one or both PCU 810 or PMIC 812. In an example, any one of PCU 810 or PMIC 812 may be absent in device 800, and hence, these components are illustrated using dotted lines.

Various power management operations of device 800 may be performed by PCU 810, by PMIC 812, or by a combination of PCU 810 and PMIC 812. For example, PCU 810 and/or PMIC 812 may select a power state (e.g., P-state) for various components of device 800. For example, PCU 810 and/or PMIC 812 may select a power state (e.g., in accordance with the ACPI (Advanced Configuration and Power Interface) specification) for various components of device 800. Merely as an example, PCU 810 and/or PMIC 812 may cause various components of the device 800 to transition to a sleep state, to an active state, to an appropriate C state (e.g., C0 state, or another appropriate C state, in accordance with the ACPI specification), etc. In an example, PCU 810 and/or PMIC 812 may control a voltage output by VR 814 and/or a frequency of a clock signal output by the clock generator, e.g., by outputting the VID signal and/or the FID signal, respectively. In an example, PCU 810 and/or PMIC 812 may control battery power usage, charging of battery 818, and features related to power saving operation.

The clock generator 816 can comprise a phase locked loop (PLL), frequency locked loop (FLL), or any suitable clock source. In some embodiments, each core of processor 804 has its own clock source. As such, each core can operate at a frequency independent of the frequency of operation of the other core. In some embodiments, PCU 810 and/or PMIC 812 performs adaptive or dynamic frequency scaling or adjustment. For example, clock frequency of a processor core can be increased if the core is not operating at its maximum power consumption threshold or limit. In some embodiments, PCU 810 and/or PMIC 812 determines the operating condition of each core of a processor, and opportunistically adjusts frequency and/or power supply voltage of that core without the core clocking source (e.g., PLL of that core) losing lock when the PCU 810 and/or PMIC 812 determines that the core is operating below a target performance level. For example, if a core is drawing current from a power supply rail less than a total current allocated for that core or processor 804, then PCU 810 and/or PMIC 812 can temporarily increase the power draw for that core or processor 804 (e.g., by increasing clock frequency and/or power supply voltage level) so that the core or processor 804 can perform at a higher performance level. As such, voltage and/or frequency can be increased temporality for processor 804 without violating product reliability.

In an example, PCU 810 and/or PMIC 812 may perform power management operations, e.g., based at least in part on receiving measurements from power measurement circuitries 842, temperature measurement circuitries 840, charge level of battery 818, and/or any other appropriate information that may be used for power management. To that end, PMIC 812 is communicatively coupled to one or more sensors to sense/detect various values/variations in one or more factors having an effect on power/thermal behavior of the system/platform. Examples of the one or more factors include electrical current, voltage droop, temperature, operating frequency, operating voltage, power consumption, inter-core communication activity, etc. One or more of these sensors may be provided in physical proximity (and/or thermal contact/coupling) with one or more components or logic/IP blocks of a computing system. Additionally, sensor(s) may be directly coupled to PCU 810 and/or PMIC 812 in at least one embodiment to allow PCU 810 and/or PMIC 812 to manage processor core energy at least in part based on value(s) detected by one or more of the sensors.

Also illustrated is an example software stack of device 800 (although not all elements of the software stack are illustrated). Merely as an example, processors 804 may execute application programs 850, Operating System 852, one or more Power Management (PM) specific application programs (e.g., generically referred to as PM applications 858), and/or the like. PM applications 858 may also be executed by the PCU 810 and/or PMIC 812. OS 852 may also include one or more PM applications 856a, 856b, 856c. The OS 852 may also include various drivers 854a, 854b, 854c, etc., some of which may be specific for power management purposes. In some embodiments, device 800 may further comprise a Basic Input/Output System (BIOS) 820. BIOS 820 may communicate with OS 852 (e.g., via one or more drivers 854), communicate with processors 804, etc.

For example, one or more of PM applications 858, 856, drivers 854, BIOS 820, etc. may be used to implement power management specific tasks, e.g., to control voltage and/or frequency of various components of device 800, to control wake-up state, sleep state, and/or any other appropriate power state of various components of device 800, control battery power usage, charging of the battery 818, features related to power saving operation, etc.

In various embodiments, SoC 801 and/or other components of device 800 include, or form at least part of, a 3D IC which spans multiple IC dice. A given two such dice are coupled to communicate with each other via one or more functional lanes, for which one or more repair lanes are each available to serve as a substitute. In an embodiment, the multiple dies provide functionality, such as that of system 100, to perform in-field lane testing and, depending on a result of such testing, in-field lane repair.

### Exemplary Computer Architectures.

Detailed below are describes of exemplary computer architectures. Other system designs and configurations known in the arts for laptop, desktop, and handheld personal computers (PC)s, personal digital assistants, engineering workstations, servers, disaggregated servers, network devices, network hubs, switches, routers, embedded processors, digital signal processors (DSPs), graphics devices, video game devices, set-top boxes, micro controllers, cell phones, portable media players, hand-held devices, and various other electronic devices, are also suitable. In general, a variety of systems or electronic devices capable of incorporating a processor and/or other execution logic as disclosed herein are generally suitable.

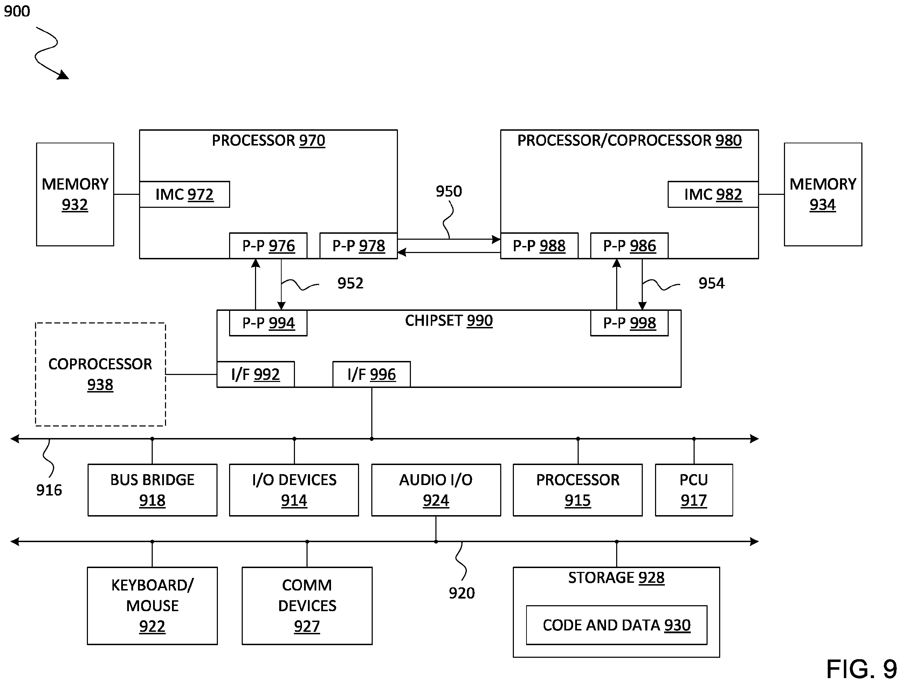

FIG. 9 illustrates an exemplary system. Multiprocessor system 900 is a point-to-point interconnect system and includes a plurality of processors including a first processor 970 and a second processor 980 coupled via a point-to-point interconnect 950. In some examples, the first processor 970 and the second processor 980 are homogeneous. In some examples, first processor 970 and the second processor 980 are heterogenous. Though the exemplary system 900 is shown to have two processors, the system may have three or more processors, or may be a single processor system.

Processors 970 and 980 are shown including integrated memory controller (IMC) circuitry 972 and 982, respectively. Processor 970 also includes as part of its interconnect controller point-to-point (P-P) interfaces 976 and 978; similarly, second processor 980 includes P-P interfaces 986 and 988. Processors 970, 980 may exchange information via the point-to-point (P-P) interconnect 950 using P-P interface circuits 978, 988. IMCs 972 and 982 couple the processors 970, 980 to respective memories, namely a memory 932 and a memory 934, which may be portions of main memory locally attached to the respective processors.

Processors 970, 980 may each exchange information with a chipset 990 via individual P-P interconnects 952, 954 using point to point interface circuits 976, 994, 986, 998. Chipset 990 may optionally exchange information with a coprocessor 938 via an interface 992. In some examples, the coprocessor 938 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 970, 980 or outside of both processors, yet connected with the processors via P-P interconnect, such that either or both processors' local cache information may be stored in the shared cache if a processor is placed into a low power mode.

Chipset 990 may be coupled to a first interconnect 916 via an interface 996. In some examples, first interconnect 916 may be a Peripheral Component Interconnect (PCI) interconnect, or an interconnect such as a PCI Express interconnect or another I/O interconnect. In some examples, one of the interconnects couples to a power control unit (PCU) 917, which may include circuitry, software, and/or firmware to perform power management operations with regard to the processors 970, 980 and/or co-processor 938. PCU 917 provides control information to a voltage regulator (not shown) to cause the voltage regulator to generate the appropriate regulated voltage. PCU 917 also provides control information to control the operating voltage generated. In various examples, PCU 917 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 917 is illustrated as being present as logic separate from the processor 970 and/or processor 980. In other cases, PCU 917 may execute on a given one or more of cores (not shown) of processor 970 or 980. In some cases, PCU 917 may be implemented as a microcontroller (dedicated or general-purpose) or other control logic configured to execute its own dedicated power management code, sometimes referred to as P-code. In yet other examples, power management operations to be performed by PCU 917 may be implemented externally to a processor, such as by way of a separate power management integrated circuit (PMIC) or another component external to the processor. In yet other examples, power management operations to be performed by PCU 917 may be implemented within BIOS or other system software.

Various I/O devices 914 may be coupled to first interconnect 916, along with a bus bridge 918 which couples first interconnect 916 to a second interconnect 920. In some examples, one or more additional processor(s) 915, such as coprocessors, high-throughput many integrated core (MIC) processors, GPGPUs, accelerators (such as graphics accelerators or digital signal processing (DSP) units), field programmable gate arrays (FPGAs), or any other processor, are coupled to first interconnect 916. In some examples, second interconnect 920 may be a low pin count (LPC) interconnect. Various devices may be coupled to second interconnect 920 including, for example, a keyboard and/or mouse 922, communication devices 927 and a storage circuitry 928. Storage circuitry 928 may be one or more non-transitory machine-readable storage media as described below, such as a disk drive or other mass storage device which may include instructions/code and data 930 in some examples. Further, an audio I/O 924 may be coupled to second interconnect 920. Note that other architectures than the point-to-point architecture described above are possible. For example, instead of the point-to-point architecture, a system such as multiprocessor system 900 may implement a multi-drop interconnect or other such architecture.

### Exemplary Core Architectures, Processors, and Computer Architectures.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may include on the same die as the described CPU (sometimes referred to as the application core(s) or application processor(s)), the above described coprocessor, and additional functionality. Exemplary core architectures are described next, followed by descriptions of exemplary processors and computer architectures.

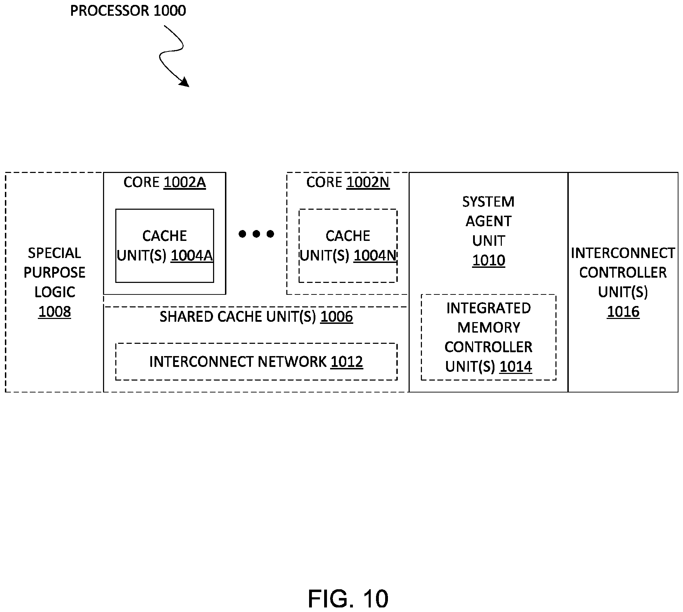

FIG. 10 illustrates a block diagram of an example processor 1000 that may have more than one core and an integrated memory controller. The solid lined boxes illustrate a processor 1000 with a single core 1002A, a system agent unit circuitry 1010, a set of one or more interconnect controller unit(s) circuitry 1016, while the optional addition of the dashed lined boxes illustrates an alternative processor 1000 with multiple cores 1002A-N, a set of one or more integrated memory controller unit(s) circuitry 1014 in the system agent unit circuitry 1010, and special purpose logic 1008, as well as a set of one or more interconnect controller units circuitry 1016. Note that the processor 1000 may be one of the processors 970 or 980, or co-processor 938 or 915 of FIG. 9.

Thus, different implementations of the processor 1000 may include: 1) a CPU with the special purpose logic 1008 being integrated graphics and/or scientific (throughput) logic (which may include one or more cores, not shown), and the cores 1002A-N being one or more general purpose cores (e.g., general purpose in-order cores, general purpose out-of-order cores, or a combination of the two); 2) a coprocessor with the cores 1002A-N being a large number of special purpose cores intended primarily for graphics and/or scientific (throughput); and 3) a coprocessor with the cores 1002A-N being a large number of general purpose in-order cores. Thus, the processor 1000 may be a general-purpose processor, coprocessor or special-purpose processor, such as, for example, a network or communication processor, compression engine, graphics processor, GPGPU (general purpose graphics processing unit circuitry), a high-throughput many integrated core (MIC) coprocessor (including 30 or more cores), embedded processor, or the like. The processor may be implemented on one or more chips. The processor 1000 may be a part of and/or may be implemented on one or more substrates using any of a number of process technologies, such as, for example, complementary metal oxide semiconductor (CMOS), bipolar CMOS (BiCMOS), P-type metal oxide semiconductor (PMOS), or N-type metal oxide semiconductor (NMOS).

A memory hierarchy includes one or more levels of cache unit(s) circuitry 1004A-N within the cores 1002A-N, a set of one or more shared cache unit(s) circuitry 1006, and external memory (not shown) coupled to the set of integrated memory controller unit(s) circuitry 1014. The set of one or more shared cache unit(s) circuitry 1006 may include one or more mid-level caches, such as level 2 (L2), level 3 (L3), level 4 (L4), or other levels of cache, such as a last level cache (LLC), and/or combinations thereof. While in some examples ring-based interconnect network circuitry 1012 interconnects the special purpose logic 1008 (e.g., integrated graphics logic), the set of shared cache unit(s) circuitry 1006, and the system agent unit circuitry 1010, alternative examples use any number of well-known techniques for interconnecting such units. In some examples, coherency is maintained between one or more of the shared cache unit(s) circuitry 1006 and cores 1002A-N.

In some examples, one or more of the cores 1002A-N are capable of multi-threading. The system agent unit circuitry 1010 includes those components coordinating and operating cores 1002A-N. The system agent unit circuitry 1010 may include, for example, power control unit (PCU) circuitry and/or display unit circuitry (not shown). The PCU may be or may include logic and components needed for regulating the power state of the cores 1002A-N and/or the special purpose logic 1008 (e.g., integrated graphics logic). The display unit circuitry is for driving one or more externally connected displays.

The cores 1002A-N may be homogenous in terms of instruction set architecture (ISA). Alternatively, the cores 1002A-N may be heterogeneous in terms of ISA; that is, a subset of the cores 1002A-N may be capable of executing an ISA, while other cores may be capable of executing only a subset of that ISA or another ISA.

### Exemplary Core Architectures -In-order and out-of-order core block diagram.

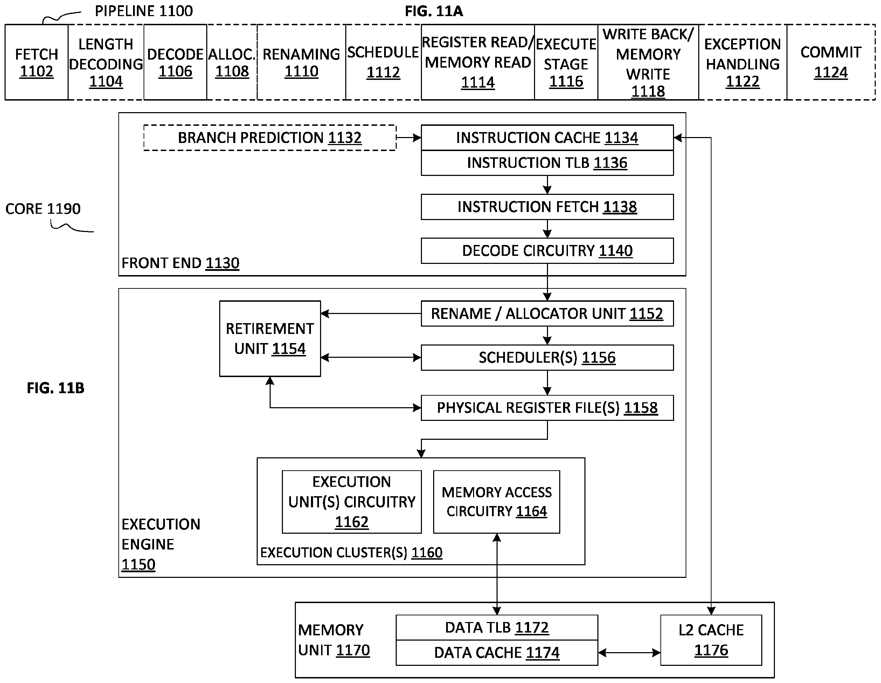

FIG. 11A is a block diagram illustrating both an exemplary in-order pipeline and an exemplary register renaming, out-of-order issue/execution pipeline according to examples. FIG. 11B is a block diagram illustrating both an exemplary example of an in-order architecture core and an exemplary register renaming, out-of-order issue/execution architecture core to be included in a processor according to examples. The solid lined boxes in FIGS. 11A-B illustrate the in-order pipeline and in-order core, while the optional addition of the dashed lined boxes illustrates the register renaming, out-of-order issue/execution pipeline and core. Given that the in-order aspect is a subset of the out-of-order aspect, the out-of-order aspect will be described.

In FIG. 11A, a processor pipeline 1100 includes a fetch stage 1102, an optional length decoding stage 1104, a decode stage 1106, an optional allocation (Alloc) stage 1108, an optional renaming stage 1110, a schedule (also known as a dispatch or issue) stage 1112, an optional register read/memory read stage 1114, an execute stage 1116, a write back/memory write stage 1118, an optional exception handling stage 1122, and an optional commit stage 1124. One or more operations can be performed in each of these processor pipeline stages. For example, during the fetch stage 1102, one or more instructions are fetched from instruction memory, and during the decode stage 1106, the one or more fetched instructions may be decoded, addresses (e.g., load store unit (LSU) addresses) using forwarded register ports may be generated, and branch forwarding (e.g., immediate offset or a link register (LR)) may be performed. In one example, the decode stage 1106 and the register read/memory read stage 1114 may be combined into one pipeline stage. In one example, during the execute stage 1116, the decoded instructions may be executed, LSU address/data pipelining to an Advanced Microcontroller Bus (AMB) interface may be performed, multiply and add operations may be performed, arithmetic operations with branch results may be performed, etc.

By way of example, the exemplary register renaming, out-of-order issue/execution architecture core of FIG. 11B may implement the pipeline 1100 as follows: 1) the instruction fetch circuitry 1138 performs the fetch and length decoding stages 1102 and 1104; 2) the decode circuitry 1140 performs the decode stage 1106; 3) the rename/allocator unit circuitry 1152 performs the allocation stage 1108 and renaming stage 1110; 4) the scheduler(s) circuitry 1156 performs the schedule stage 1112; 5) the physical register file(s) circuitry 1158 and the memory unit circuitry 1170 perform the register read/memory read stage 1114; the execution cluster(s) 1160 perform the execute stage 1116; 6) the memory unit circuitry 1170 and the physical register file(s) circuitry 1158 perform the write back/memory write stage 1118; 7) various circuitry may be involved in the exception handling stage 1122; and 8) the retirement unit circuitry 1154 and the physical register file(s) circuitry 1158 perform the commit stage 1124.

FIG. 11B shows a processor core 1190 including front-end unit circuitry 1130 coupled to an execution engine unit circuitry 1150, and both are coupled to a memory unit circuitry 1170. The core 1190 may be a reduced instruction set architecture computing (RISC) core, a complex instruction set architecture computing (CISC) core, a very long instruction word (VLIW) core, or a hybrid or alternative core type. As yet another option, the core 1190 may be a special-purpose core, such as, for example, a network or communication core, compression engine, coprocessor core, general purpose computing graphics processing unit (GPGPU) core, graphics core, or the like.

The front end unit circuitry 1130 may include branch prediction circuitry 1132 coupled to an instruction cache circuitry 1134, which is coupled to an instruction translation lookaside buffer (TLB) 1136, which is coupled to instruction fetch circuitry 1138, which is coupled to decode circuitry 1140. In one example, the instruction cache circuitry 1134 is included in the memory unit circuitry 1170 rather than the front-end circuitry 1130. The decode circuitry 1140 (or decoder) may decode instructions, and generate as an output one or more micro-operations, micro-code entry points, microinstructions, other instructions, or other control signals, which are decoded from, or which otherwise reflect, or are derived from, the original instructions. The decode circuitry 1140 may further include an address generation unit (AGU, not shown) circuitry. In one example, the AGU generates an LSU address using forwarded register ports, and may further perform branch forwarding (e.g., immediate offset branch forwarding, LR register branch forwarding, etc.). The decode circuitry 1140 may be implemented using various different mechanisms. Examples of suitable mechanisms include, but are not limited to, look-up tables, hardware implementations, programmable logic arrays (PLAs), microcode read only memories (ROMs), etc. In one example, the core 1190 includes a microcode ROM (not shown) or other medium that stores microcode for certain macroinstructions (e.g., in decode circuitry 1140 or otherwise within the front end circuitry 1130). In one example, the decode circuitry 1140 includes a micro-operation (micro-op) or operation cache (not shown) to hold/cache decoded operations, micro-tags, or micro-operations generated during the decode or other stages of the processor pipeline 1100. The decode circuitry 1140 may be coupled to rename/allocator unit circuitry 1152 in the execution engine circuitry 1150.

The execution engine circuitry 1150 includes the rename/allocator unit circuitry 1152 coupled to a retirement unit circuitry 1154 and a set of one or more scheduler(s) circuitry 1156. The scheduler(s) circuitry 1156 represents any number of different schedulers, including reservations stations, central instruction window, etc. In some examples, the scheduler(s) circuitry 1156 can include arithmetic logic unit (ALU) scheduler/scheduling circuitry, ALU queues, arithmetic generation unit (AGU) scheduler/scheduling circuitry, AGU queues, etc. The scheduler(s) circuitry 1156 is coupled to the physical register file(s) circuitry 1158. Each of the physical register file(s) circuitry 1158 represents one or more physical register files, different ones of which store one or more different data types, such as scalar integer, scalar floating-point, packed integer, packed floating-point, vector integer, vector floating-point, status (e.g., an instruction pointer that is the address of the next instruction to be executed), etc. In one example, the physical register file(s) circuitry 1158 includes vector registers unit circuitry, writemask registers unit circuitry, and scalar register unit circuitry. These register units may provide architectural vector registers, vector mask registers, general-purpose registers, etc. The physical register file(s) circuitry 1158 is coupled to the retirement unit circuitry 1154 (also known as a retire queue or a retirement queue) to illustrate various ways in which register renaming and out-of-order execution may be implemented (e.g., using a reorder buffer(s) (ROB(s)) and a retirement register file(s); using a future file(s), a history buffer(s), and a retirement register file(s); using a register maps and a pool of registers; etc.). The retirement unit circuitry 1154 and the physical register file(s) circuitry 1158 are coupled to the execution cluster(s) 1160. The execution cluster(s) 1160 includes a set of one or more execution unit(s) circuitry 1162 and a set of one or more memory access circuitry 1164. The execution unit(s) circuitry 1162 may perform various arithmetic, logic, floating-point or other types of operations (e.g., shifts, addition, subtraction, multiplication) and on various types of data (e.g., scalar integer, scalar floating-point, packed integer, packed floating-point, vector integer, vector floating-point). While some examples may include a number of execution units or execution unit circuitry dedicated to specific functions or sets of functions, other examples may include only one execution unit circuitry or multiple execution units/execution unit circuitry that all perform all functions. The scheduler(s) circuitry 1156, physical register file(s) circuitry 1158, and execution cluster(s) 1160 are shown as being possibly plural because certain examples create separate pipelines for certain types of data/operations (e.g., a scalar integer pipeline, a scalar floating-point/packed integer/packed floating-point/vector integer/vector floating-point pipeline, and/or a memory access pipeline that each have their own scheduler circuitry, physical register file(s) circuitry, and/or execution cluster - and in the case of a separate memory access pipeline, certain examples are implemented in which only the execution cluster of this pipeline has the memory access unit(s) circuitry 1164). It should also be understood that where separate pipelines are used, one or more of these pipelines may be out-of-order issue/execution and the rest in-order.

In some examples, the execution engine unit circuitry 1150 may perform load store unit (LSU) address/data pipelining to an Advanced Microcontroller Bus (AMB) interface (not shown), and address phase and writeback, data phase load, store, and branches.

The set of memory access circuitry 1164 is coupled to the memory unit circuitry 1170, which includes data TLB circuitry 1172 coupled to a data cache circuitry 1174 coupled to a level 2 (L2) cache circuitry 1176. In one exemplary example, the memory access circuitry 1164 may include a load unit circuitry, a store address unit circuit, and a store data unit circuitry, each of which is coupled to the data TLB circuitry 1172 in the memory unit circuitry 1170. The instruction cache circuitry 1134 is further coupled to the level 2 (L2) cache circuitry 1176 in the memory unit circuitry 1170. In one example, the instruction cache 1134 and the data cache 1174 are combined into a single instruction and data cache (not shown) in L2 cache circuitry 1176, a level 3 (L3) cache circuitry (not shown), and/or main memory. The L2 cache circuitry 1176 is coupled to one or more other levels of cache and eventually to a main memory.

The core 1190 may support one or more instructions sets (e.g., the x86 instruction set architecture (optionally with some extensions that have been added with newer versions); the MIPS instruction set architecture; the ARM instruction set architecture (optionally with optional additional extensions such as NEON)), including the instruction(s) described herein. In one example, the core 1190 includes logic to support a packed data instruction set architecture extension (e.g., AVX1, AVX2), thereby allowing the operations used by many multimedia applications to be performed using packed data.

### Exemplary Execution Unit(s) Circuitry.

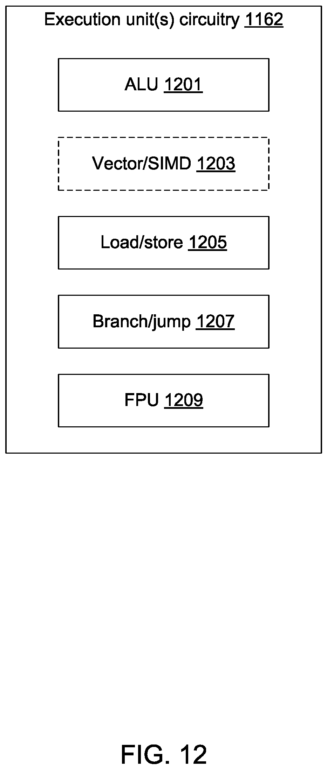

FIG. 12 illustrates examples of execution unit(s) circuitry, such as execution unit(s) circuitry 1162 of FIG. 11B. As illustrated, execution unit(s) circuity 1162 may include one or more ALU circuits 1201, optional vector/single instruction multiple data (SIMD) circuits 1203, load/store circuits 1205, branch/jump circuits 1207, and/or Floating-point unit (FPU) circuits 1209. ALU circuits 1201 perform integer arithmetic and/or Boolean operations. Vector/SIMD circuits 1203 perform vector/SIMD operations on packed data (such as SIMD/vector registers). Load/store circuits 1205 execute load and store instructions to load data from memory into registers or store from registers to memory. Load/store circuits 1205 may also generate addresses. Branch/jump circuits 1207 cause a branch or jump to a memory address depending on the instruction. FPU circuits 1209 perform floating-point arithmetic. The width of the execution unit(s) circuitry 1162 varies depending upon the example and can range from 16-bit to 1,024-bit, for example. In some examples, two or more smaller execution units are logically combined to form a larger execution unit (e.g., two 128-bit execution units are logically combined to form a 256-bit execution unit).

### Exemplary Register Architecture

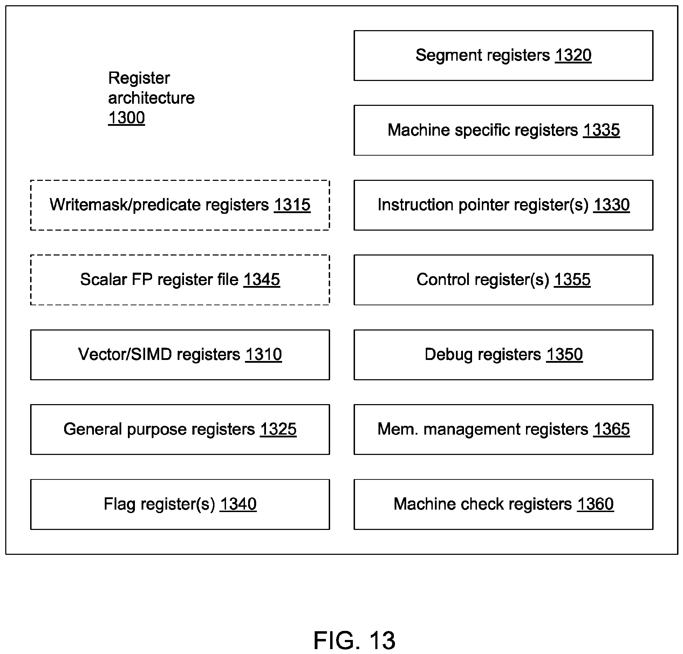

FIG. 13 is a block diagram of a register architecture 1300 according to some examples. As illustrated, the register architecture 1300 includes vector/SIMD registers 1310 that vary from 128-bit to 1,024 bits width. In some examples, the vector/SIMD registers 1310 are physically 512-bits and, depending upon the mapping, only some of the lower bits are used. For example, in some examples, the vector/SIMD registers 1310 are ZMM registers which are 512 bits: the lower 256 bits are used for YMM registers and the lower 128 bits are used for XMM registers. As such, there is an overlay of registers. In some examples, a vector length field selects between a maximum length and one or more other shorter lengths, where each such shorter length is half the length of the preceding length. Scalar operations are operations performed on the lowest order data element position in a ZMM/YMM/XMM register; the higher order data element positions are either left the same as they were prior to the instruction or zeroed depending on the example.

In some examples, the register architecture 1300 includes writemask/predicate registers 1315. For example, in some examples, there are 8 writemask/predicate registers (sometimes called k0 through k7) that are each 16-bit, 32-bit, 64-bit, or 128-bit in size. Writemask/predicate registers 1315 may allow for merging (e.g., allowing any set of elements in the destination to be protected from updates during the execution of any operation) and/or zeroing (e.g., zeroing vector masks allow any set of elements in the destination to be zeroed during the execution of any operation). In some examples, each data element position in a given writemask/predicate register 1315 corresponds to a data element position of the destination. In other examples, the writemask/predicate registers 1315 are scalable and consists of a set number of enable bits for a given vector element (e.g., 8 enable bits per 64-bit vector element).

The register architecture 1300 includes a plurality of general-purpose registers 1325. These registers may be 16-bit, 32-bit, 64-bit, etc. and can be used for scalar operations. In some examples, these registers are referenced by the names RAX, RBX, RCX, RDX, RBP, RSI, RDI, RSP, and R8 through R15.

In some examples, the register architecture 1300 includes scalar floating-point (FP) register 1345 which is used for scalar floating-point operations on 32/64/80-bit floating-point data using the x87 instruction set architecture extension or as MMX registers to perform operations on 64-bit packed integer data, as well as to hold operands for some operations performed between the MMX and XMM registers.

One or more flag registers 1340 (e.g., EFLAGS, RFLAGS, etc.) store status and control information for arithmetic, compare, and system operations. For example, the one or more flag registers 1340 may store condition code information such as carry, parity, auxiliary carry, zero, sign, and overflow. In some examples, the one or more flag registers 1340 are called program status and control registers.

Segment registers 1320 contain segment points for use in accessing memory. In some examples, these registers are referenced by the names CS, DS, SS, ES, FS, and GS.

Machine specific registers (MSRs) 1335 control and report on processor performance. Most MSRs 1335 handle system-related functions and are not accessible to an application program. Machine check registers 1360 consist of control, status, and error reporting MSRs that are used to detect and report on hardware errors.

One or more instruction pointer register(s) 1330 store an instruction pointer value. Control register(s) 1355 (e.g., CR0-CR4) determine the operating mode of a processor (e.g., processor 970, 980, 938, 915, and/or 1000) and the characteristics of a currently executing task. Debug registers 1350 control and allow for the monitoring of a processor or core's debugging operations.

Memory (mem) management registers 1365 specify the locations of data structures used in protected mode memory management. These registers may include a GDTR, IDRT, task register, and a LDTR register.

Alternative examples may use wider or narrower registers. Additionally, alternative examples may use more, less, or different register files and registers. The register architecture 1300 may, for example, be used in physical register file(s) circuitry 1158.

In the following description, numerous details are discussed to provide a more thorough explanation of the embodiments of the present disclosure. It will be apparent to one skilled in the art, however, that embodiments of the present disclosure may be practiced without these specific details. In other instances, well-known structures and devices are shown in block diagram form, rather than in detail, in order to avoid obscuring embodiments of the present disclosure.

Note that in the corresponding drawings of the embodiments, signals are represented with lines. Some lines may be thicker, to indicate a greater number of constituent signal paths, and/or have arrows at one or more ends, to indicate a direction of information flow. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

Throughout the specification, and in the claims, the term "connected" means a direct connection, such as electrical, mechanical, or magnetic connection between the things that are connected, without any intermediary devices. The term "coupled" means a direct or indirect connection, such as a direct electrical, mechanical, or magnetic connection between the things that are connected or an indirect connection, through one or more passive or active intermediary devices. The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

The term "scaling" generally refers to converting a design (schematic and layout) from one process technology to another process technology and subsequently being reduced in layout area. The term "scaling" generally also refers to downsizing layout and devices within the same technology node. The term "scaling" may also refer to adjusting (e.g., slowing down or speeding up - i.e. scaling down, or scaling up respectively) of a signal frequency relative to another parameter, for example, power supply level.

The terms "substantially," "close," "approximately," "near," and "about," generally refer to being within +/- 10% of a target value. For example, unless otherwise specified in the explicit context of their use, the terms "substantially equal," "about equal" and "approximately equal" mean that there is no more than incidental variation between among things so described. In the art, such variation is typically no more than +/-10% of a predetermined target value.

It is to be understood that the terms so used are interchangeable under appropriate circumstances such that the embodiments of the invention described herein are, for example, capable of operation in other orientations than those illustrated or otherwise described herein.

Unless otherwise specified the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. It is pointed out that those elements of a figure having the same reference numbers (or names) as the elements of any other figure can operate or function in any manner similar to that described, but are not limited to such.

In addition, the various elements of combinatorial logic and sequential logic discussed in the present disclosure may pertain both to physical structures (such as AND gates, OR gates, or XOR gates), or to synthesized or otherwise optimized collections of devices implementing the logical structures that are Boolean equivalents of the logic under discussion.

Techniques and architectures for supporting in-field lane testing and/or repair for a 3D IC are described herein. In the above description, for purposes of explanation, numerous specific details are set forth in order to provide a thorough understanding of certain embodiments. It will be apparent, however, to one skilled in the art that certain embodiments can be practiced without these specific details. In other instances, structures and devices are shown in block diagram form in order to avoid obscuring the description.

Reference in the specification to "one embodiment" or "an embodiment" means that a particular feature, structure, or characteristic described in connection with the embodiment is included in at least one embodiment of the invention. The appearances of the phrase "in one embodiment" in various places in the specification are not necessarily all referring to the same embodiment.

Some portions of the detailed description herein are presented in terms of algorithms and symbolic representations of operations on data bits within a computer memory. These algorithmic descriptions and representations are the means used by those skilled in the computing arts to most effectively convey the substance of their work to others skilled in the art. An algorithm is here, and generally, conceived to be a self-consistent sequence of steps leading to a desired result. The steps are those requiring physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. Unless specifically stated otherwise as apparent from the discussion herein, it is appreciated that throughout the description, discussions utilizing terms such as "processing" or "computing" or "calculating" or "determining" or "displaying" or the like, refer to the action and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

Certain embodiments also relate to apparatus for performing the operations herein. This apparatus may be specially constructed for the required purposes, or it may comprise a general purpose computer selectively activated or reconfigured by a computer program stored in the computer. Such a computer program may be stored in a computer readable storage medium, such as, but is not limited to, any type of disk including floppy disks, optical disks, CD-ROMs, and magnetic-optical disks, read-only memories (ROMs), random access memories (RAMs) such as dynamic RAM (DRAM), EPROMs, EEPROMs, magnetic or optical cards, or any type of media suitable for storing electronic instructions, and coupled to a computer system bus.

The algorithms and displays presented herein are not inherently related to any particular computer or other apparatus. Various general purpose systems may be used with programs in accordance with the teachings herein, or it may prove convenient to construct more specialized apparatus to perform the required method steps. The required structure for a variety of these systems will appear from the description herein. In addition, certain embodiments are not described with reference to any particular programming language. It will be appreciated that a variety of programming languages may be used to implement the teachings of such embodiments as described herein.

In one or more first embodiments, an integrated circuit (IC) die comprises a hardware interface to couple the IC die to another IC die, wherein the IC die and the other IC die are to form, at least in part, a three-dimensional (3D) IC, a test unit to receive status information from a power management control (PMC) agent during an in-field operation of the 3D IC, the test unit further to detect, based on the status information, a first condition wherein a first partition of the IC die, and a second partition of the other IC die, are each in a respective idle state, wherein the 3D IC comprises a first lane between the first partition and the second partition, and detect a second condition wherein one or more communications via the first lane fail to satisfy a performance criteria, and mode circuitry coupled to the hardware interface and to the test unit, wherein, based on the second condition, and during the first condition, the test unit is to signal the mode circuitry to disable a first conductive path between the first lane and the first partition, and further to enable a second conductive path between a second lane of the 3D IC and the first partition.

In one or more second embodiments, further to the first embodiment, the test unit is a first test unit, and wherein multiple partitions of the 3D IC are each to correspond to a different respective one of multiple test units, the multiple partitions are to comprise the first partition and the second partition, and for each test unit of the multiple test units the PMC agent is to be coupled to provide respective status information to the test unit, and the test unit is to participate in a respective lane test based on the respective status information.

In one or more third embodiments, further to the second embodiment, the multiple partitions are each to operate in a first clock domain.

In one or more fourth embodiments, further to the third embodiment, the first condition is to be occur while one or more of the multiple partitions are each in a respective active state.

In one or more fifth embodiments, further to the second embodiment, the first partition comprises a first signal source circuit, the second partition is to comprise a first signal sink circuit, a third partition of the multiple partitions is to comprise a second signal source circuit of the other IC die, and a fourth partition of the multiple partitions comprises a second signal sink circuit of the IC die.

In one or more sixth embodiments, further to the first embodiment or the second embodiment, the test unit is further to receive test data from the PMC agent, and perform a communication of the test data from the IC die via the first lane, the other IC die is to generate a value based on the communication, and the test unit is to detect the second condition based on a mismatch between the value and a reference value.

In one or more seventh embodiments, further to the first embodiment or the second embodiment, the test unit is further to receive performance information from a sensor which is coupled to the first lane, the test unit to detect the second condition comprises the test unit to identify, based on the performance information, a failure of a performance metric to satisfy a threshold condition, and the performance metric is to be based on one or more communications via the first lane.

In one or more eighth embodiments, further to the seventh embodiment, the performance metric is a setup time metric.

In one or more ninth embodiments, further to the first embodiment or the second embodiment, interface circuitry, coupled between the PMC agent and the test unit, is to provide the status information via a bus which is compatible with a test bus standard.

In one or more tenth embodiments, further to the ninth embodiment, the test bus standard is identified in an Institute of Electrical and Electronics Engineers (IEEE) 1149.1 specification.

In one or more eleventh embodiments, a method comprises receiving, at a test unit of a first integrated circuit (IC) die, status information from a power management control (PMC) agent, wherein the first IC die and a second IC die are coupled to form, at least in part, a three-dimensional (3D) IC, wherein the test unit receives the status information during an in-field operation of the 3D IC, based on the status information, detecting a first condition wherein a first partition of the first IC die, and a second partition of the second IC die, are each in a respective idle state, wherein the 3D IC comprises a first lane between the first partition and the second partition, detecting a second condition wherein one or more communications via the first lane fail to satisfy a performance criteria, based on the second condition, and during the first condition disabling a first conductive path between the first lane and the first partition, and enabling a second conductive path between a second lane of the 3D IC and the first partition.

In one or more twelfth embodiments, further to the eleventh embodiment, the test unit is a first test unit, and wherein multiple partitions of the 3D IC each correspond to a different respective one of multiple test units, the multiple partitions comprise the first partition and the second partition, and for each test unit of the multiple test units the PMC agent is coupled to provide respective status information to the test unit, and the test unit is to participate in a respective lane test based on the respective status information.

In one or more thirteenth embodiments, further to the twelfth embodiment, the multiple partitions are each to operate in a first clock domain.

In one or more fourteenth embodiments, further to the thirteenth embodiment, the first condition is while one or more of the multiple partitions are each in a respective active state.

In one or more fifteenth embodiments, further to the twelfth embodiment, the first partition comprises a first signal source circuit, the second partition comprises a first signal sink circuit, a third partition of the multiple partitions comprises a second signal source circuit of the second IC die, and a fourth partition of the multiple partitions comprises a second signal sink circuit of the first IC die.

In one or more sixteenth embodiments, further to the eleventh embodiment or the twelfth embodiment, the method further comprises receiving, at the test unit, test data from the PMC agent, and performing a communication of the test data from the first IC die via the first lane, wherein the second IC die generates a value based on the communication, and wherein the second condition is detected based on a mismatch between the value and a reference value.

In one or more seventeenth embodiments, further to the eleventh embodiment or the twelfth embodiment, the method further comprises receiving, at the test unit, performance information from a sensor which is coupled to the first lane, wherein detecting the second condition comprises identifying, based on the performance information, a failure of a performance metric to satisfy a threshold condition, wherein the performance metric is based on one or more communications via the first lane.

In one or more eighteenth embodiments, further to the seventeenth embodiment, the performance metric is a setup time metric.

In one or more nineteenth embodiments, further to the eleventh embodiment or the twelfth embodiment, interface circuitry, coupled between the PMC agent and the test unit, provides the status information via a bus which is compatible with a test bus standard.

In one or more twentieth embodiments, further to the nineteenth embodiment, the test bus standard is identified in an Institute of Electrical and Electronics Engineers (IEEE) 1149.1 specification.

In one or more twenty-first embodiments, a system comprises a first integrated circuit (IC) die and a second IC die coupled to each other to form, at least in part, a three-dimensional (3D) IC, wherein the first IC die comprises a test unit to receive status information from a power management control (PMC) agent during an in-field operation of the 3D IC, the test unit further to detect, based on the status information, a first condition wherein a first partition of the IC die, and a second partition of the other IC die, are each in a respective idle state, wherein the 3D IC comprises a first lane between the first partition and the second partition, and detect a second condition wherein one or more communications via the first lane fail to satisfy a performance criteria, and mode circuitry coupled to the test unit, wherein, based on the second condition, and during the first condition, the test unit is to signal the mode circuitry to disable a first conductive path between the first lane and the first partition, and further to enable a second conductive path between a second lane of the 3D IC and the first partition, and a memory interface to communicate a signal between the 3D IC and a memory.

In one or more twenty-second embodiments, further to the twenty-first embodiment, the test unit is a first test unit, and wherein multiple partitions of the 3D IC are each to correspond to a different respective one of multiple test units, the multiple partitions are to comprise the first partition and the second partition, and for each test unit of the multiple test units the PMC agent is to be coupled to provide respective status information to the test unit, and the test unit is to participate in a respective lane test based on the respective status information.

In one or more twenty-third embodiments, further to the twenty-second embodiment, the multiple partitions are each to operate in a first clock domain.

In one or more twenty-fourth embodiments, further to the twenty-third embodiment, the first condition is to be occur while one or more of the multiple partitions are each in a respective active state.

In one or more twenty-fifth embodiments, further to the twenty-second embodiment, the first partition comprises a first signal source circuit, the second partition is to comprise a first signal sink circuit, a third partition of the multiple partitions is to comprise a second signal source circuit of the other IC die, and a fourth partition of the multiple partitions comprises a second signal sink circuit of the IC die.

In one or more twenty-sixth embodiments, further to the twenty-first embodiment or the twenty-second embodiment, the test unit is further to receive test data from the PMC agent, and perform a communication of the test data from the IC die via the first lane, the other IC die is to generate a value based on the communication, and the test unit is to detect the second condition based on a mismatch between the value and a reference value.

In one or more twenty-seventh embodiments, further to the twenty-first embodiment or the twenty-second embodiment, the test unit is further to receive performance information from a sensor which is coupled to the first lane, the test unit to detect the second condition comprises the test unit to identify, based on the performance information, a failure of a performance metric to satisfy a threshold condition, and the performance metric is to be based on one or more communications via the first lane.

In one or more twenty-eighth embodiments, further to the twenty-seventh embodiment, the performance metric is a setup time metric.

In one or more twenty-ninth embodiments, further to the twenty-first embodiment or the twenty-second embodiment, interface circuitry, coupled between the PMC agent and the test unit, is to provide the status information via a bus which is compatible with a test bus standard.

In one or more thirtieth embodiments, further to the twenty-ninth embodiment, the test bus standard is identified in an Institute of Electrical and Electronics Engineers (IEEE) 1149.1 specification.

Besides what is described herein, various modifications may be made to the disclosed embodiments and implementations thereof without departing from their scope. Therefore, the illustrations and examples herein should be construed in an illustrative, and not a restrictive sense. The scope of the invention should be measured solely by reference to the claims that follow.

## Claims

1. An integrated circuit (IC) die comprising:
a hardware interface to couple the IC die to another IC die, wherein the IC die and the other IC die are to form, at least in part, a three-dimensional (3D) IC;
a test unit to receive status information from a power management control (PMC) agent during an in-field operation of the 3D IC, the test unit further to:
detect, based on the status information, a first condition wherein a first partition of the IC die, and a second partition of the other IC die, are each in a respective idle state, wherein the 3D IC comprises a first lane between the first partition and the second partition; and
detect a second condition wherein one or more communications via the first lane fail to satisfy a performance criteria; and
mode circuitry coupled to the hardware interface and to the test unit;
wherein, based on the second condition, and during the first condition, the test unit is to signal the mode circuitry to disable a first conductive path between the first lane and the first partition, and further to enable a second conductive path between a second lane of the 3D IC and the first partition.

2. The IC die of claim 1, wherein the test unit is a first test unit, and wherein:
multiple partitions of the 3D IC are each to correspond to a different respective one of multiple test units;
the multiple partitions are to comprise the first partition and the second partition; and
for each test unit of the multiple test units:
the PMC agent is to be coupled to provide respective status information to the test unit; and
the test unit is to participate in a respective lane test based on the respective status information.

3. The IC die of claim 2, wherein the multiple partitions are each to operate in a first clock domain.

4. The IC die of claim 3, wherein the first condition is to occur while one or more of the multiple partitions are each in a respective active state.

5. The IC die of claim 2, wherein:
the first partition comprises a first signal source circuit;
the second partition is to comprise a first signal sink circuit;
a third partition of the multiple partitions is to comprise a second signal source circuit of the other IC die; and
a fourth partition of the multiple partitions comprises a second signal sink circuit of the IC die.

6. The IC die of claim 1, wherein:
the test unit is further to:
receive test data from the PMC agent; and
perform a communication of the test data from the IC die via the first lane;
the other IC die is to generate a value based on the communication; and
the test unit is to detect the second condition based on a mismatch between the value and a reference value.

7. The IC die of claim 1, wherein:
the test unit is further to receive performance information from a sensor which is coupled to the first lane;
the test unit to detect the second condition comprises the test unit to identify, based on the performance information, a failure of a performance metric to satisfy a threshold condition; and
the performance metric is to be based on one or more communications via the first lane.

8. The IC die of claim 7, wherein the performance metric is a setup time metric.

9. The IC die of claim 1, wherein interface circuitry, coupled between the PMC agent and the test unit, is to provide the status information via a bus which is compatible with a test bus standard.

10. The IC die of claim 9, wherein the test bus standard is identified in an Institute of Electrical and Electronics Engineers (IEEE) 1149.1 specification.

11. A method comprising:
receiving, at a test unit of a first integrated circuit (IC) die, status information from a power management control (PMC) agent, wherein the first IC die and a second IC die are coupled to form, at least in part, a three-dimensional (3D) IC, wherein the test unit receives the status information during an in-field operation of the 3D IC;
based on the status information, detecting a first condition wherein a first partition of the first IC die, and a second partition of the second IC die, are each in a respective idle state, wherein the 3D IC comprises a first lane between the first partition and the second partition;
detecting a second condition wherein one or more communications via the first lane fail to satisfy a performance criteria;
based on the second condition, and during the first condition:
disabling a first conductive path between the first lane and the first partition; and
enabling a second conductive path between a second lane of the 3D IC and the first partition.

12. The method of claim 11, wherein the test unit is a first test unit, and wherein:
multiple partitions of the 3D IC each correspond to a different respective one of multiple test units;
the multiple partitions comprise the first partition and the second partition; and
for each test unit of the multiple test units:
the PMC agent is coupled to provide respective status information to the test unit; and
the test unit is to participate in a respective lane test based on the respective status information.

13. The method of claim 12, wherein:
the first partition comprises a first signal source circuit;
the second partition comprises a first signal sink circuit;
a third partition of the multiple partitions comprises a second signal source circuit of the second IC die; and
a fourth partition of the multiple partitions comprises a second signal sink circuit of the first IC die.

14. The method of claim 11, further comprising:
receiving, at the test unit, test data from the PMC agent; and
performing a communication of the test data from the first IC die via the first lane;
wherein the second IC die generates a value based on the communication, and wherein the second condition is detected based on a mismatch between the value and a reference value.

15. The method of claim 11, further comprising:
receiving, at the test unit, performance information from a sensor which is coupled to the first lane;
wherein detecting the second condition comprises identifying, based on the performance information, a failure of a performance metric to satisfy a threshold condition, wherein the performance metric is based on one or more communications via the first lane.
